# EUROPEAN PATENT APPLICATION

(11) **EP 2 341 538 A2**
(43) Date of publication of application: **06.07.2011**
(21) Application number: 10197438.4
(22) Date of filing: 30.12.2010
(51) Int. Cl.: H01L 27/06, H01L 27/088

(54) **Voltage converter with integrated Schottky device and systems including same**

(30) Priority: 30.12.2009 US 291107 P; 05.10.2010 US 898664
(71) Applicant: Intersil Americas Inc., Milpitas, CA 95035 (US)
(72) Inventor: Girdhar, Dev Alok, Indiatlantic, FL 32903 (US); Hebert, Francois, San Mateo, CA 94402 (US)
(74) Representative: Fleuchaus, Michael A.

(57) **Abstract**

A semiconductor device such as a voltage converter includes a circuit stage such as an output stage having a high side device (14) and a low side device (16) which can be formed on a single die (i.e., a "PowerDie") and connected to each other through a semiconductor substrate, and further includes a Schottky diode (620) integrated with at least one of the low side device and the high side device. Both the high side device and the low side device can include lateral diffused metal oxide semiconductor (LDMOS) transistors. Because both output transistors include the same type of transistors, the two devices can be formed simultaneously, thereby reducing the number of photomasks over other voltage converter designs. The voltage converter can further include a controller circuit on a different die which can be electrically coupled to, and co-packaged with, the PowerDie. Various embodiments of the Schottky diode can provide Schottky protection and, additionally JFET protection for the Schottky device.

## Description

### Cross-Reference to Related Application

This application claims the benefit of U.S. Provisional Patent Application 61/291,107 filed December 30, 2009, the disclosure of which is incorporated herein by reference.

### Incorporation by Reference

Each of the following is incorporated herein by reference: U.S. Patent Application Serial No.12/796,178 filed June 8, 2010; U.S. Patent Application Serial No. 12/770,074 filed April 28, 2010; U.S. Patent Application Serial No. 12/470,229, filed May 21, 2009; U.S. Patent Application Serial No. 12/471,911, filed May 26, 2009; U.S. Patent Application Serial No. 12/477,818, filed June 3, 2009.

### Description of the Embodiments

Reference below is made in detail to exemplary embodiments of the present teachings, examples of which are illustrated in the accompanying drawings. Wherever possible, the same reference numbers will be used throughout the drawings to refer to the same or like parts. The accompanying drawings, which are incorporated in and constitute a part of this specification, illustrate embodiments of the invention and together with the description, serve to explain the principles of the invention. In the figures:

FIG. 1 is a bottom view of a power converter device in accordance with an embodiment of the invention;

FIG. 2 is a schematic block diagram of an embodiment of a voltage converter device including low side and high side output power devices on a single die;

FIGS. 3-7 are cross sections depicting various embodiments in accordance with the present teachings;

FIGS. 8-17 are cross sections of intermediate structures which can be formed in accordance with one or more embodiments of the present teachings;

FIGS. 18-53 are cross sections of other embodiments of the present teachings;

FIG. 54 is a block diagram of an electronic system which can be formed according to an embodiment of the present teachings;

FIGS. 55A and 55B are cross sections depicting a semiconductor wafer substrate assembly attached to a lead frame; and

FIG. 56 is a schematic block diagram of an embodiment of a voltage converter device including low side and high side output power devices on a single die, along with a Schottky diode on the single die.

It should be noted that some details of the FIGS. have been simplified and are drawn to facilitate understanding of the inventive embodiments rather than to maintain strict structural accuracy, detail, and scale.

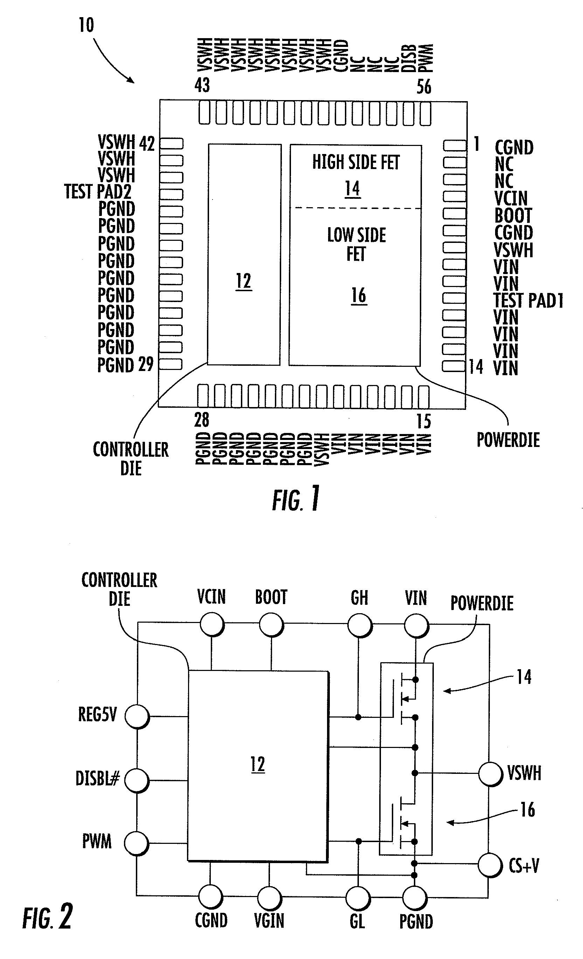

FIG. 1 depicts a semiconductor device 10 in accordance with an embodiment of the present teachings. FIG. 1 depicts at least a portion of a direct current (DC) to DC converter with co-packaged semiconductor dies. The co-packaged dies can include a first integrated circuit (IC) die with control circuitry 12 (i.e., a controller die). The control circuitry 12 can include one or more metal oxide semiconductor field effect transistors (MOSFETs). FIG. 1 further depicts a second MOSFET die (i.e., a "PowerDie," defined below) including one or more high side FETs 14 (i.e., high side circuitry or high side circuit device) and one or more low side FETs 16 (i.e., low side circuitry or low side device) on a single semiconductor die, such as a single piece of silicon, gallium arsenide, or other semiconductor material. A block diagram of a DC to DC converter device is depicted in FIG. 2, which also depicts controller circuitry 12, high side circuitry 14 connected to a V_{IN} pinout and adapted to be electrically coupled with V_{IN} during device operation, and low side circuitry 16 connected to a power ground (P_{GND}) pinout and adapted to be electrically coupled with P_{GND} during device operation. The interconnection between the high side device 14 and the low side device 16 between V_{IN} and P_{GND} is referred to as a "half bridge." A semiconductor device voltage converter in accordance with an embodiment of the present teachings can include the package pinouts and pin assignments such as those depicted in the FIGS.

Examples of devices which can be formed in accordance with the present teachings include, but are not limited to, a non-synchronous buck DC to DC converter (i.e., "non-synch buck" converter) with co-packaged high side MOSFET and external Schottky diode, a non-synch buck DC to DC converter with co-packaged high side and low side MOSFETs, a synchronous buck DC to DC converter with co-packaged high side and low side MOSFETs, a boost DC to DC converter with co-packaged MOSFETs (synchronous boost), and a boost DC to DC converter with co-packaged MOSFET and Schottky diodes, among others.

A device design incorporating a single die including both a low side device and high side device on a single die is referred to herein as a "PowerDie." A PowerDie can include both a high side power transistor and a low side power transistor on a single piece of silicon or other semiconductor substrate. One type of PowerDie is disclosed in co-pending U.S. Pat. Application Serial No. 12/470,229, filed May 21, 2009 and titled "Co-Packaging Approach for Power Converters Based on Planar Devices, Structure and Method." This application, commonly assigned with the present application and incorporated herein by reference, describes the use of a PowerDie along with a controller die having controller circuitry on a separate die which can be packaged separately and placed on a supporting substrate such as a printed circuit board (PCB), or which can be co-packaged as two separate dies into a single semiconductor device, such as an encapsulated semiconductor device. The platform of the PowerDie referenced in the incorporated application can integrate a trench field effect transistor (FET) acting as a low side FET and a lateral FET with a deep trench side acting as a high side FET.

The teachings of the present disclosure below describe a PowerDie which can include various power output converting structures and attributes. This implementation of a PowerDie can employ the use of lateral FETs as transistors for both the low side and the high side devices. Also, a drain of the low side FET can be connected to a source of the high side FET through a semiconductor substrate and a deep trench metal. Additionally, a process to form the device may include a reduced number of masks by using the same process features for both high side and low side FETs. The resulting device may provide improved performance at higher switching frequencies, which can result from a reduced gate charge for the low side FET. Because of a reduced R_{ON}*Q figure of merit, the device may have reduced power losses at high switching frequencies (e.g. frequencies ≥ about 700 kHz), a high duty cycle application (e.g. a V_{OUT} of about 0.5*V_{IN}), and a low current application (e.g. an operating current less than about 1.0 A). A device in accordance with the present teachings can be tailored for any voltage rating, particularly between about 5 V to about 100 V, for example about 30 volts.

As used herein, a "P-body region" refers to a "P-type body region" and does not indicate a doping level. Generally, a P-body region will be doped to a P+ doping level as described below. Similarly, a "P-buried layer" refers to a "P-type buried layer, while an "N-epitaxial layer" refers to an "N-type epitaxial layer." Specific doping levels for the P-buried layer and the N-epitaxial layer are discussed below.

It will be understood that the embodiments below describe the formation of two lateral N-channel diffusion metal oxide semiconductor (NDMOS) devices at separate locations on the same piece of silicon or other semiconductor substrate, but it will be recognized that the description can be modified to form two lateral PDMOS devices. The devices can be formed at locations on the die which are remote from each other as represented below and in the FIGS., or the devices can be adjacent to each other. Further, because a method of the present teachings is described in reference to the formation of two lateral NDMOS devices, the body region (for example) is described as a P-body region (i.e., a P-type body region), while this structure will be an N-body region (i.e., an N-type body region) for a lateral PDMOS device, and is referred to generically as a "body region." Additionally, the "P-buried layer" (PBL, a "P-type buried layer) is referred to generically as a "buried layer."

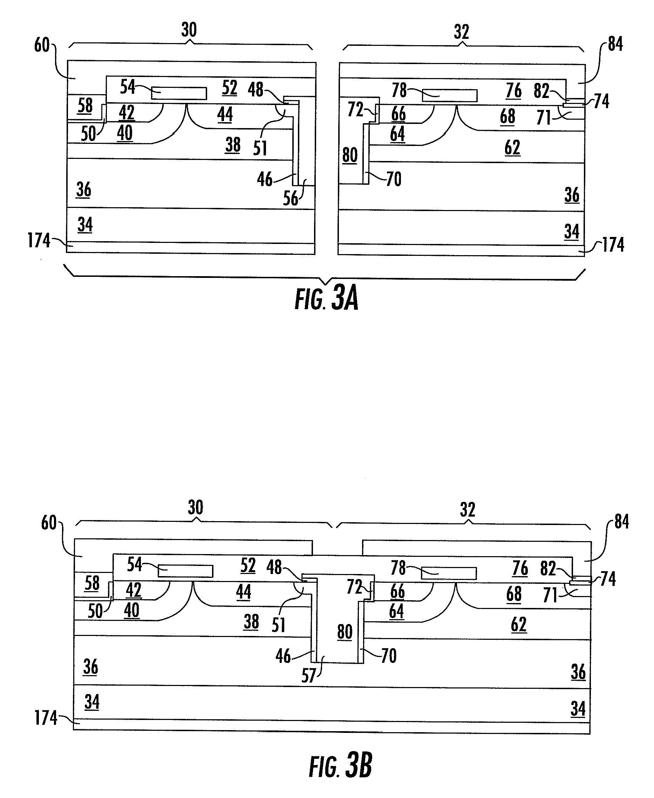

FIG. 3A depicts an embodiment of the present teachings, which can include devices formed to provide a PowerDie. As depicted in FIG. 3A, the PowerDie includes a low side FET 30 as a low side circuit device and a high side FET 32 as a high side circuit device. The low side FET 30 and the high side FET 32 are depicted as being separated to emphasize that they can be formed at separate locations on a single semiconductor substrate (such as a silicon semiconductor wafer) and, during use, can reside at separate locations on a single semiconductor die. However, they can also be formed adjacent to each other such that, for example, trench conductor 56 and trench conductor 80 (described below) in FIG. 3A are the same structure. This alternate embodiment is depicted in FIG. 3B, wherein FETs 30, 32 are formed adjacent to each other with a trench conductor 57 interposed between the two FETs.

The low side FET 30 can include, for example: a semiconductor substrate 34 doped to an N+ conductivity and having a doping concentration of about 1 E18 to about 1 E20 atoms/cm³; a grown, deposited, or attached epitaxial semiconductor layer 36 doped to an N-type conductivity having a doping concentration of about 1 E14 to about 1 E 18 atoms/cm³, but lower than the doping concentration of the N+ semiconductor substrate; a P-doped buried layer (also referred to herein as a "P-buried layer", "PBL", or "deep body") 38 having a doping concentration of about 1 E15 to about 1 E18 atoms/cm³; a P-body region 40 doped to a P-type conductivity having a doping concentration of about 1 E16 to about 1 E18 atoms/cm³; an N+ source region 42 having a doping concentration of about 1E18 to about 5E20 atoms/cm³; an N-drift region 44 having a doping concentration of about 1 E14 to about 1 E 17 atoms/cm³; an N+ doped isolation region 46 having a doping concentration of about 1 E 18 to about 5E20 atoms/cm³; silicide structures 48, 50; an N+ doped drain region 51 having a doping concentration of about 1E18 to about 5E20 atoms/cm³; dielectric 52; a conductive gate 54; a conductive layer which forms a trench conductor 56 and a source contact 58; and a conductive source metal 60.

The high side device 32 can include, for example: the semiconductor substrate 34 doped to the N+ conductivity to doping concentration of about 1E18 to about 1 E20 atoms/cm³; the grown, deposited, or attached epitaxial semiconductor layer 36 doped to an N-type conductivity to a doping concentration of about 1 E14 to about 1 E18 atoms/cm³, but lower than the N+ doping concentration of the N+ semiconductor substrate; a P-doped buried layer 62 (also referred to herein as a "P-buried layer" or "PBL") having a doping concentration of about 1 E15 to about 1 E18 atoms/cm³; a P-body region 64 doped to a P-type conductivity and having a doping concentration of about 1 E16 to about 1E18 atoms/cm³; an N+ source region 66 having a doping concentration of about 1 E18 to about 5E20 atoms/cm³; an N-drift region 68 having a doping concentration of about 1 E14 to about 1E17 atoms/cm³; an N+ doped isolation region 70 having a doping concentration of about 1 E18 to about 5E20 atoms/cm³; an N+ doped drain region 71 having a doping concentration of about 1 E18 to about 5E20 atoms/cm³; silicide structures 72, 74; dielectric 76; a conductive gate 78; a conductive layer which forms a trench conductor 80 and a source contact 82; and a conductive drain metal 84.

It will be noted that various structures for the low side FET 30 and the high side FET 32 can be formed from the same implant or layer as discussed below and will thus have the same dopant concentration, but may be numbered differently for ease of explanation.

The N+ isolation regions 46, 70 can be formed by ion implantation into the sidewalls of the trenches to isolate trench conductors 56, 80 from the P-buried layers 38, 62 respectively. The low side device drain region 51 is electrically coupled to the trench conductor 56 through silicide structure 48, and the trench conductor 56 electrically couples the low side device drain region 51 to the N+ semiconductor substrate 34 through the N-type epitaxial semiconductor layer 36. The high side device source region 66 is electrically coupled to the trench conductor 80 through silicide structure 72, and the trench conductor 80 electrically couples the high side device source region 66 to the N+ semiconductor substrate 34 through the N-type epitaxial semiconductor layer 36. Thus, the low side drain region 51 is electrically connected to the high side source region 66. The conductive source metal 60 can be electrically coupled with a device ground (P_{GND}) pinout, while the conductive drain metal 84 can be electrically coupled with a voltage in (V_{IN}) pinout, for example in accordance with the circuit schematic of FIG. 2. The lower surface of the substrate (the bottom of layer 34) can be contacted, for example with a conductive layer 174 such as a metal layer, to supply an output node of the output stage.

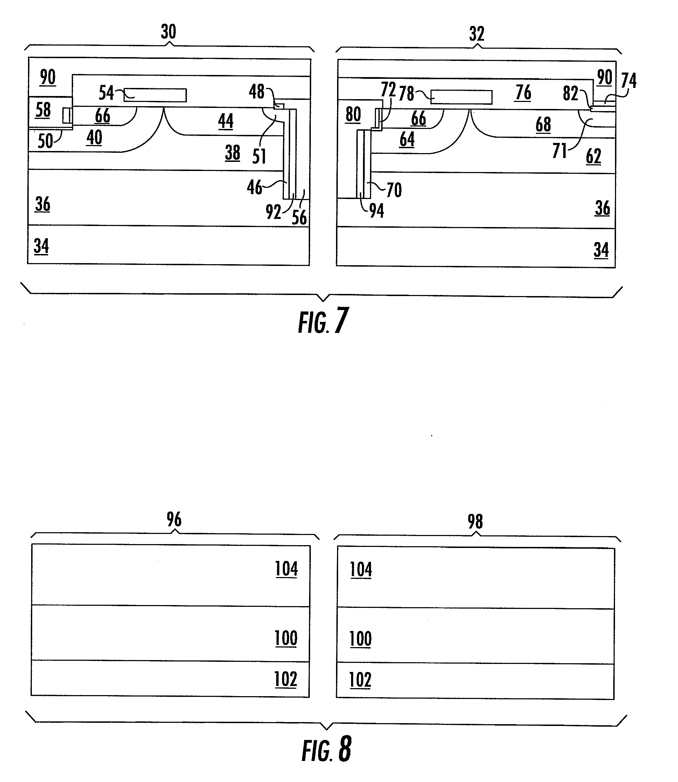

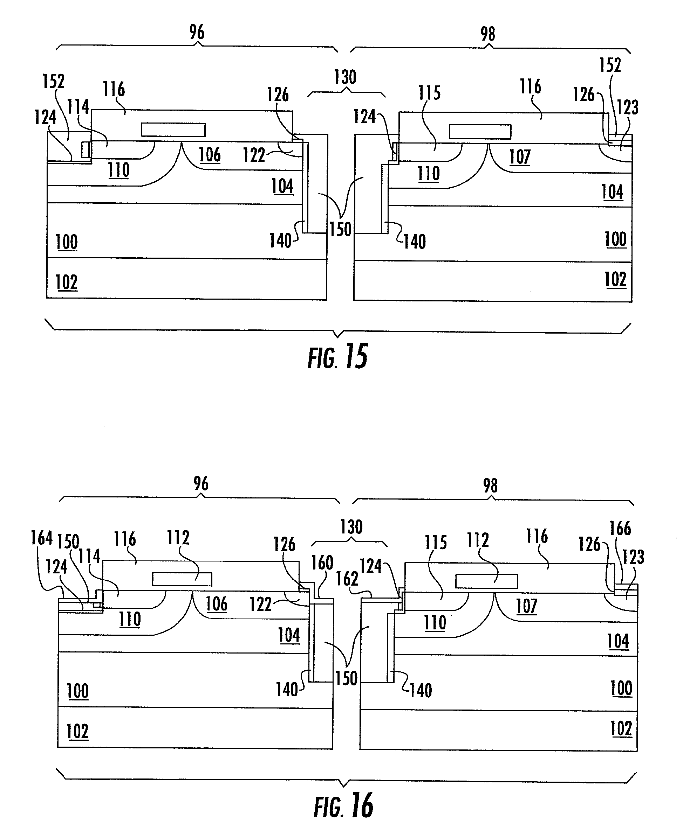

A method for forming the structure of FIG. 3 will be evident from the methods and structures depicted and described below, for example a method similar to that depicted in FIGS. 8-17. An alternate embodiment is depicted in FIG. 16, which is described in the text below. Additionally, the function of each structure will become apparent from the following description and the accompanying depictions.

Both the low side FET 30 and the high side FET 32 can be formed during a single process which simultaneously forms similar layers on each device. For example, the low side P-body region 40 and the high side P-body region 64 can be simultaneously implanted during a single doping sequence. Similarly, a source implant can form the source 42 of the low side device and the source 66 of the high side device.

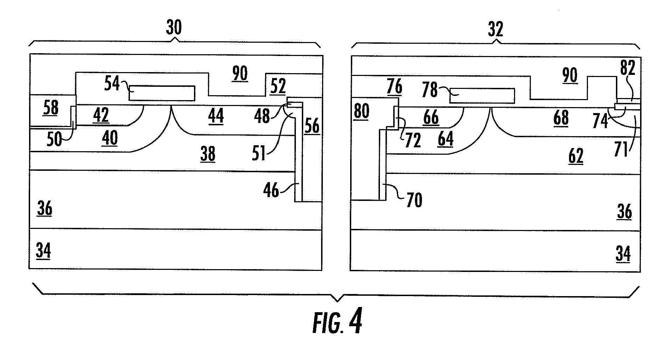

FIG. 4 depicts an embodiment similar to that of FIG. 3, except that dielectric 52 surrounding the low side conductive gate 54 and high side conductive gate 78 is graded (stepped) by the overlying metal layer 90. That is, the dielectric surrounding each gate is not planar across an upper surface as depicted in FIG. 3, but rather the metal 90 overlying the dielectric 52, 76 extends down into an opening in the dielectric. The embodiment of FIG. 4 can thus include both a trench with an N+ sidewall 46 on the low side and graded dielectric 52, 76 such as a graded oxide.

The FIG. 4 structure may result in a more desirable on-resistance (RDS_{ON}) vs. breakdown voltage trade-off than the FIG. 3 structure, such that improved performance can be achieved. For a typical power device, RDS_{ON} increases with increasing breakdown voltage. However, the rate at which this voltage increases can be different for different device types. It is preferred to minimize RDS_{ON} for a given voltage or voltage range. A device can be configured so that for a given voltage or voltage range, the RDS_{ON} is lower for that voltage or voltage range. The device with lower RDS_{ON} in a given voltage or voltage range is said to have a more desirable RDS_{ON} vs. breakdown voltage trade-off.

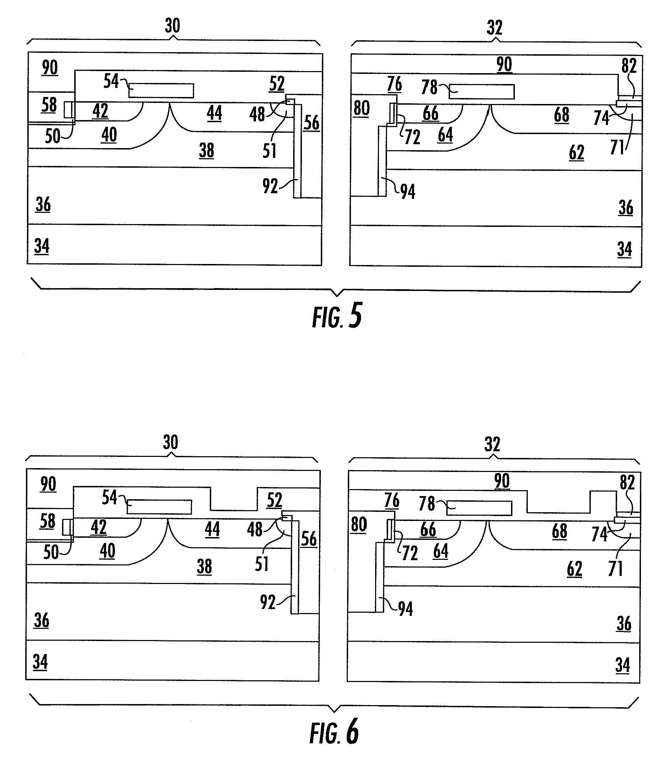

The FIG. 5 structure includes structures similar to that of FIG. 3 and additionally includes a first dielectric liner 92 on the trench sidewall of the low side FET and a second dielectric liner 94 on the trench sidewall of the high side FET. Using dielectric liners 92, 94 such as silicon dioxide as depicted in FIG. 5 rather than the implanted N+ sidewalls 46, 70 such as those depicted of FIG. 3 may provide improved device isolation and reduced process complexity in some uses.

The FIG. 6 structure combines the dielectric liners 92, 94 such as those depicted in the FIG. 5 structure along with a graded (stepped) dielectric 90 such as that depicted in FIG. 4 which surrounds the conductive FET gates 54, 78.

The FIG. 7 structure includes both dielectric liners 92, 94 along the sidewalls of the trenches such as those depicted in FIG. 5 and N+ implanted regions 46, 70 similar to those depicted in FIG. 3 which are adjacent to the dielectric liners. Including both implanted isolation and dielectric liners as insulation may result in improved electrical isolation.

FIGS. 8-17 are cross sections of intermediate structures which can be formed in accordance with one or more embodiments of the present teachings. It will be understood by one of ordinary skill in the art that modification of the processes can result in any of the devices depicted in FIGS. 3-7, 16, and 17.

An embodiment of a process which will result in the formation of a low side FET 96 at a first wafer location and a high side FET 98 at a second wafer location can begin with the manufacture of the FIG. 8 structure which can be formed using various methods. For example, an N-type epitaxial layer 100 can be formed on an N+ semiconductor substrate 102, followed by the formation of a P-type epitaxial layer 104 doped to a P- conductivity (which will provide a PBL) on the N-type epitaxial layer 100.

In an alternate process, an N-type epitaxial layer can be formed on an N+ semiconductor substrate, and then the N-type epitaxial layer is counterdoped at an upper region to provide a net P-type conductivity to a P- level to form what will be the PBL, to provide a similar structure to that depicted in FIG. 8.

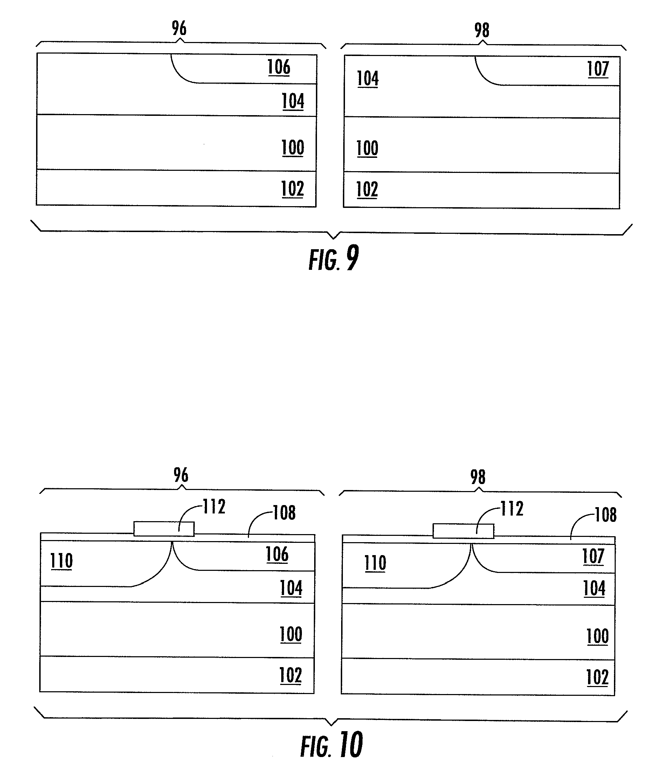

Subsequently, an active region can be defined at another wafer location, for example by a localized oxidation of silicon (LOCOS) process, then patterned N-drift regions 106, 107 are implanted into the P-buried layers 104 for the low side 96 and high side 98 devices respectively, for example using a photolithographic process, to result in the FIG. 9 structure. Even though the N-drift regions can be implanted simultaneously using a single processing sequence, the N-drift region 106 of the low side device 96 has been numbered differently from the N-drift region 107 of the high side device 98 for descriptive clarity.

Processing on the FIG. 9 structure can continue with a growth of transistor gate dielectric 108 such as a high quality oxide, patterning and doping of a P-body region 110 for both the low side FET 96 and the high side FET 98, and patterning and doping of the low side and high side transistor gates 112, for example using a photoresist and one or more ion implantation sequences in accordance with known techniques to result in the FIG. 10 structure. The transistor gates can be formed from a deposited layer, for example polysilicon, that is patterned after deposition. Gate polysilicon can be doped during deposition (i.e., *in situ* doped) or doped in a separate implantation after deposition, or both. If made from a highly conductive material such as metal, the transistor gates can remain undoped. In another embodiment, the transistor gates112 can be formed prior to implanting the P-body regions 110, in which case the P-type implant to form the P-body regions 110 will be self-aligned through blocking of the implant by the transistor gates 112 and non-active regions.

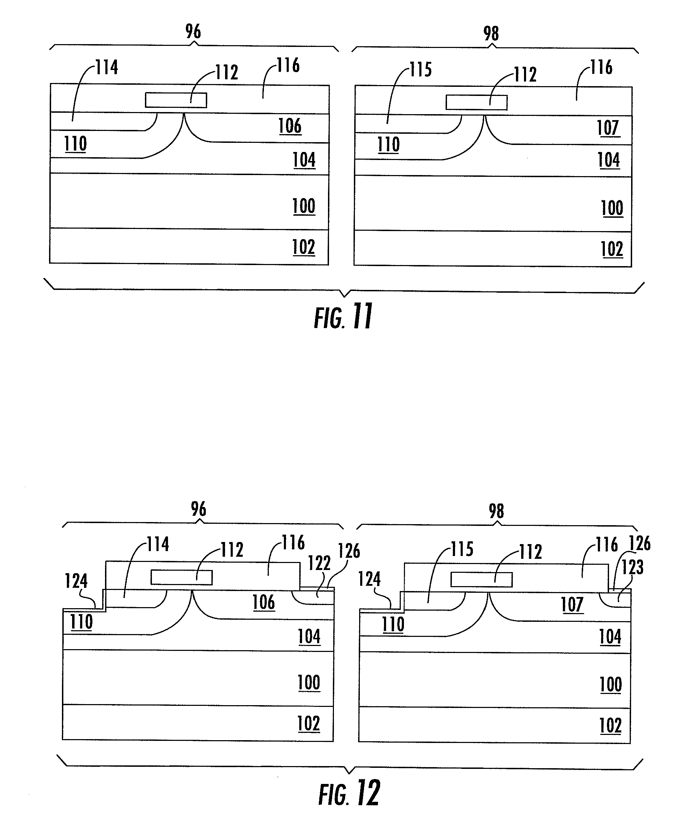

Next, patterned N+ source regions 114, 115 can be implanted for the low side FET 96 and the high side FET 98 respectively. In an alternate embodiment, the N+ drain regions 122, 123 for the low side and high side FETs, discussed below, can be implanted using the source mask which defines the N+ source regions 114, 115. An interlevel dielectric (ILD) layer, for example an oxide material, is formed over the gate dielectric layer and over the transistor gates 112 to result in the FIG. 11. Dielectric layer 116 thus includes both an ILD layer and the gate dielectric oxide 108 of FIG. 10.

The FIG. 11 structure can then be processed using a photomask to cover the low side device 96 and the high side device 98, except for a portion of the N-drift regions 106, 107 which are left unmasked (uncovered). The dielectric 116 is etched from over the N-drift regions 106, 107, the mask is removed, then an N+ implant is performed to form the low side FET drain region 122 and the high side FET drain region 123 within the N-drift regions 106, 107 respectively. The resulting N+ drain regions 122, 123 within N-drift regions 106, 107, depicted in FIG. 12, provide highly conductive implanted N+ drain contacts to the N-drift regions 106, 107. As discussed above, in an alternate embodiment, the N+ drain contacts 122, 123 can be implanted using the source mask which defines N+ source regions 114, 115. Next, P-body contacts are formed using a mask which leaves the P-body regions 110 of the low side FET 96 and the high side FET 98 uncovered. An etch is performed to remove exposed portions of the dielectric layer 116 and the N+ source regions 114, 115 as depicted in FIG. 12.

An optional shallow P-type implant can be performed to ensure that the regions exposed by the mask are doped to a P-type conductivity, for example in the event that an inadvertent under etch is performed which does not completely remove N+ source layers 114, 115 from over the P-body regions 110.

After etching the source regions 114, 115, the mask can be removed, then a self-aligned silicide (i.e., salicide) process can be performed to result in the FIG. 12 structure. FIG. 12 depicts silicide contacts 124 to the P-body regions 110 of both the low side FET 96 and the high side FET 98, as well as silicide contacts 126 to the drain region 122 of the low side FET 98 and to the drain region 123 of the high side FET 98. Even though the salicide 124, 126 can be formed during a single salicide process, the salicide structures 124 on the P-body regions 110 are numbered separately from the salicide structures 126 on the drain regions 122, 123 for descriptive clarity.

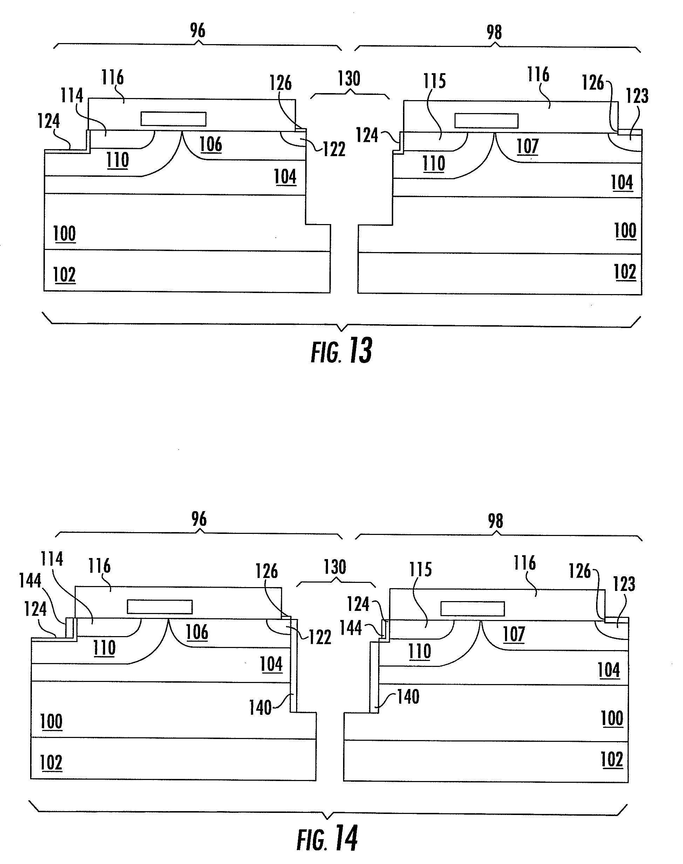

Next, a patterned deep trench etch is performed to result in the substrate trench 130 of FIG. 13. It should be noted that if the low side FET 96 and the high side FET 98 are being formed at locations which are remote from each other, the substrate trench 130 will include two trenches, one for the low side FET and one for the high side FET. If the two FETs are being formed adjacent to each other, the substrate trench 130 may be a single trench.

The trench can be etched deep enough to extend below the low side FET drain region 122, the low side FET N-drift region 106, the low side FET PBL 104, the high side source region 115, the high side FET P-body region 110, the high side FET PBL 104, and at least expose an N+ doped region within the epitaxial layer 100. The N+ doped region within the N-epitaxial layer results from outdiffusion of dopants from the N+ substrate 102 and into the N-type epitaxial layer 100. Further, the substrate trench 130 should be narrower than the silicide contact 124 to the high side FET 98 as well as the silicide contact 126 to the low side FET drain region 122. Additionally, this trench etch removes a portion of these silicide contacts 124, 126 and forms vertically oriented sidewalls in the silicide contacts 124, 126 as depicted in FIG. 13. An optional N+ implant (not depicted) into the trench bottom can be performed to function as a channel stop.

In an alternate embodiment, the substrate trench 130 is etched to a depth which is sufficient to expose the N+ doped semiconductor substrate 102.

As discussed above relative to FIGS. 3, 5, and 7, an implanted N+ isolation region can be formed within at least the low side FET substrate trench sidewall. In these embodiments, the trench sidewall is doped, for example using an angled N+ ion implantation into the low side trench sidewall. The N+ isolation prevents electrical contact between a subsequently formed trench conductor and the P-buried layer 104 of the low side device.

In an embodiment, performing the angled N+ implant into the low side FET trench sidewall but omitting the N+ implantation into the substrate trench sidewall of the high side FET can be advantageous. For example, omitting the N+ implant from the high side FET substrate trench sidewall can result in reduced process complexity because outdiffusion of dopants into the high side FET during subsequent anneal steps is avoided. The diffusion of N+ dopants into the high side device may reduce electrical performance resulting from the source of the high side FET being close to the substrate trench, while the source of the low side FET is at a location more removed from the substrate trench as depicted. As discussed previously, the implant can be performed into both substrate trench sidewalls (high side FET and low side FET) as depicted in FIG. 3.

Next, a dielectric such as oxide can deposited, for example to a thickness of about 0.1 µm, then anisotropically etched, for example using a spacer etch. This will result in dielectric spacers or liners 140 within the substrate trench 130 and also dielectric spacers or liners 144 covering other vertical surfaces such as the silicide contacts 124 as depicted in FIG. 14. The process to form dielectric liners 140 will provide the liners as depicted in the various embodiments of FIGS. 5-7, however this dielectric deposition is not performed form the embodiments depicted in FIGS. 3 and 4.

Subsequently, a blanket conductor such as titanium, tungsten, or polysilicon is filled within the trench and etched back or planarized to result in the FIG. 15 structure having a patterned trench conductor 150 and other conductive structures 152. The conductive layer 150, 152 can either be left above the level of the silicide contacts 126 as depicted in FIG. 15, or it can be etched back below the level of the silicide contacts 126 as depicted in FIG. 16. Etching back the conductive layer 150, 152 as depicted in FIG. 16 may have an advantage of permitting direct contact to the silicide contacts 126 after etching back the blanket dielectric which forms liners 144. However, in some cases, it may be desirable to omit an etch back of the trench conductive layer 150, 152 as it may damage silicide contacts 124, 126.

As depicted in FIG. 15, the dielectric liner 140 along a first trench sidewall on the side of the low side FET is interposed between trench conductor 150 and the P-buried layer 104 of the low side FET 96. Similarly, the dielectric liner 140 along a second trench sidewall on the side of the high side FET is interposed between the trench conductor 150 and the P-buried layer 104 of the high side FET.

In the FIG. 16 device, continuing with the process as described below may not result in electrical connection between the low side FET drain region 122 and the trench conductor 150. In the FIG. 16 embodiment, a self-aligned silicide (i.e., salicide) process can be used with a polysilicon trench fill to form silicide structures 160 to electrically connect low side FET drain region 122 with trench conductor 150, which would also form silicide structures 162, 164 and 166.

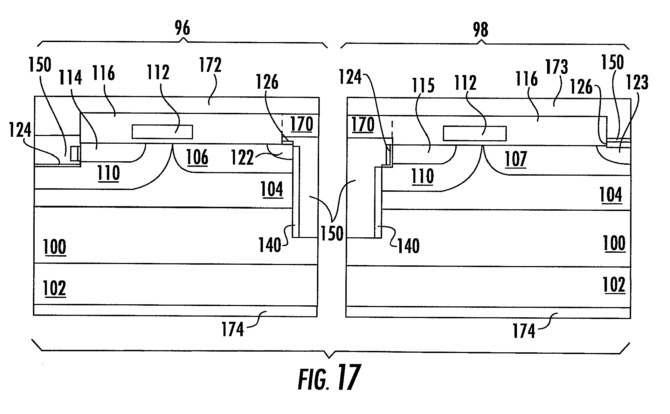

After forming the FIG. 15 structure (or, optionally, the FIG. 16 structure) wafer processing can continue to form a completed semiconductor device. This can include the formation of a dielectric layer 170 such as oxide to cover the trench conductor 150, a patterned conductive layer 172, 173, for example metal, over the dielectric layer 170, and a back side conductor 174 such as a metal layer as depicted in FIG. 17. The patterned conductive layer 172, which is depicted as overlying the transistor gate 112 of the low side FET 96, can be connected to a device ground (P_{GND}) pinout, which can be electrically connected to P_{GND} during device operation. The patterned conductive layer 173, which is depicted as overlying the transistor gate 112 of the high side FET 98 can be connected to a voltage in (V_{IN}) pinout, which can be electrically connected to V_{IN} during operation. In the embodiments of FIGS. 4 and 6, an intervening patterned dielectric etch would be performed to result in the stepped (graded) oxide as depicted in FIGS. 4 and 6. An optional passivation layer can be formed.

If the low side FET 96 and the high side FET 98 are formed at locations which are remote from each other, the N+ drain region 122 of the low side FET 96 (referring to FIG. 17, for example) is connected to the N+ source region 115 of the high side FET 98 through low side silicide contact 126, low side FET trench conductor 150, N-type epitaxial layer 100, high side trench conductor 150, and high side silicide source contact 124.

If the low side FET 96 and the high side FET 98 are formed adjacent to each other so that the trench conductor 150 for both devices is a single conductive structure, the N+ drain region 122 of the low side FET 96 (referring to FIG. 17, for example) is connected to the N+ source region 115 of the high side FET 98 through low side silicide contact 126, low side FET and high side FET trench conductor 150, and high side FET silicide source contact 124. In this embodiment, the trench conductor 150 is used to electrically connect with the back side of the device, and the conductive layer 174, to provide an output of the device as described below.

The back side conductor 174 can supply an output of the DC to DC power converter device output stage, with the output stage including the low side FET 96 and the high side FET 98. The back side conductor 174 of FIG. 17 can thus provide the output (i.e., a phase or phase node) of the output stage, with the output stage of a DC to DC power converter including the low side FET 96 and the high side FET 98.

Thus, the FIG. 17 device includes a front side (also referred to herein as "circuit side," and "upper surface") of the semiconductor wafer section having circuitry (e.g. transistor structures such as transistor gates 112) thereon, and a back side with a conductive layer 174 thereon. The back side is opposite the front side. The low side FET 96 and the high side FET 98 can both include LDMOS transistor FETs. The output stage for a DC-DC power converter includes the low side FET and the high side FET, with both low side LDMOS and high side LDMOS output devices on a single piece of semiconductor material such as silicon or gallium arsenide (e.g. on a single die). In an embodiment, patterned conductive layer 173 and thus the drain region 123 of the high side device 98 is electrically connected to device voltage in (V_{IN}) which is the voltage to be converted. Patterned conductive layer 172 and thus the source region 114 of the low side device 96 is tied to device ground (P_{GND}). An output of the output stage can be include conductive layer 174 on the back side of the device.

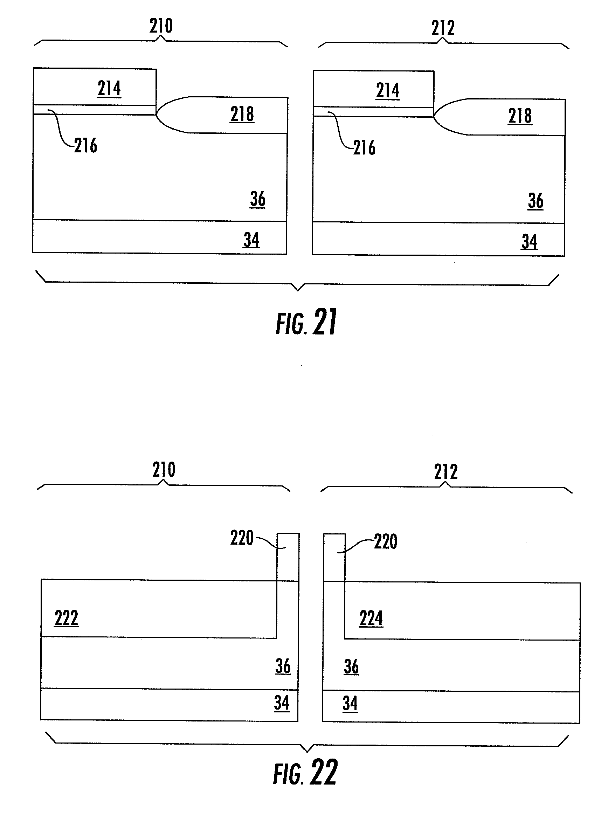

In the FIG. 17 device, the drain region 122 of the low side device 96 is electrically the same point as the source region 115 of the high side device 98, which provides an output node of the DC to DC power converter output stage. The drain region 122 of the low side FET 96 is electrically connected to the back side (also referred to herein as "non-circuit side," "lower surface") of the semiconductor die on which the high side and low side FETs are formed. This connection to the output node of the output device can be made using a physical connection through metal 150, and the semiconductor substrate 102. The physical connection can include a conductive path from the surface, through the N-type epitaxial layer 100, to reach the N+ semiconductor substrate 102. This conductive path can include a conductive structure such as the conductive trench conductor 150 as depicted. In another embodiment, a conductive structure such as an implanted diffusion region (i.e., a sinker) can be formed in place of the trench conductor. A sinker embodiment is described below with reference to FIGS. 21-32. The back side of the die, therefore, can provide an output node for the power device output stage, which can simplify electrical connections. Electrical connection to the output node can include an electrical connection to conductive layer 174, and can be accomplished with a conductive die attach material, for example.

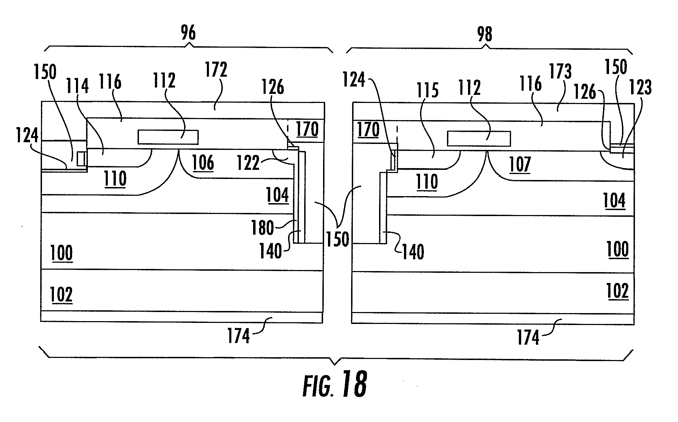

FIG. 18 depicts an embodiment similar to that depicted in FIG. 17, including a first substrate trench sidewall on the side of the low side FET, and a second substrate trench sidewall on the side of the high side FET. A doped electrical isolation region 180 is implanted into the first substrate trench sidewall, but there is no corresponding doped region implanted into the second sidewall. Thus, the implanted region 180 is interposed between the trench conductor 150 and the P-buried layer 104 of the low side FET 96, but there is no corresponding doped region interposed between the trench conductor 150 and the buried layer 110 of the high side FET 98.

The doped electrical isolation region 180 of FIG. 18 may electrically isolate the P-buried layer 104 of the low side FET 96 from the trench conductor 150 better than the dielectric spacer or line 140 alone. Thus, this embodiment depicts both a dielectric spacer or liner 140 and a doped isolation region 180 on the sidewall of the low side FET 96, and only a dielectric spacer or liner 140 on the sidewall of the high side FET 98.

This embodiment can be formed using an angled N+ implant into the first sidewall but not the second sidewall, and thus, there is no corresponding N+ region on the second sidewall. Omitting the N+ implant from the second sidewall can result in reduced process complexity because outdiffusion of dopants into the high side FET during subsequent anneal steps is avoided. The diffusion of N+ dopants into the high side device may reduce electrical performance resulting from the source region 115 of the high side FET 98 being close to the second sidewall of the substrate trench, while the source region 114 of the low side FET 96 is at a location more removed from the first sidewall of the substrate trench.

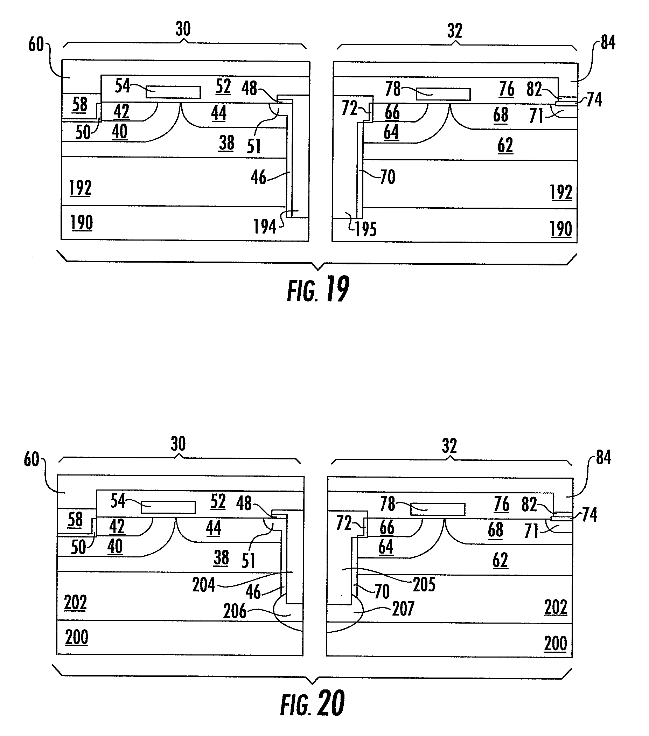

FIG. 19 depicts an N-channel LDMOS (N-LDMOS) device which can be formed according to a method of the present teachings. The FIG. 19 device includes elements which can be similar to those depicted in FIG. 3 and are similarly numbered. As discussed above, the FIG. 3 device can include an N+ semiconductor substrate 34 and an epitaxial layer 36 doped to a low doped N doping concentration, and is formed using a substrate trench etch which stops with a bottom in the epitaxial layer 36. The FIG. 19 device can include a semiconductor substrate 190 which is heavily doped with N-type dopants (i.e., doped to a N+ doping concentration), an epitaxial layer 192 which is low doped with P-type dopants (i.e., doped to a P doping concentration), and can be formed using a trench etch which stops with a bottom in the semiconductor substrate 190 so that the trench conductor 194, 195 contacts the N+ semiconductor substrate 190. The N+ semiconductor substrate can have a N-type doping concentration of about 1 E18 to about 5E20 atoms/cm³, and the P-type epitaxial layer can have a P-type doping concentration of about 1 E 16 to about 1 E 18 atoms/cm³.

Thus, the FIG. 19 device can provide a low side N-channel LDMOS device 30 and a high side N-channel LDMOS device 32 on an N+ semiconductor substrate 190 and a P epitaxial layer 192. With this device, the low side N-type drain 51 can form a PN junction between N-doped isolation 46 and PBL 38. In N-channel device embodiments where the semiconductor substrate is N+ and the epitaxial layer is N doped, for example the embodiment of FIG. 3A, the N-type drain 51 of the low side device 30 forms an NPN junction with P-doped buried layer 38 and N-type epitaxial layer 36, which requires tighter process control because of resulting NPN parasitics to ensure that the robustness of the N-channel device is not reduced.

With prior embodiments, continuing the substrate trench etch so that the bottom of the substrate trench is within the semiconductor substrate provides for a low resistance contact between a trench conductor within the substrate trench and the semiconductor substrate 190. In most of the embodiments described above, the substrate trench can be etched to the depth of the P+ or N+ substrate to provide for a low resistance contact between the trench conductor and the semiconductor substrate. Depending on the thickness of various layers and the width of the substrate trench, however, there may be a limit on the depth of the trench. Thus, other embodiments can stop within the P or N epitaxial layer with, for example, outdiffusion of dopants from the semiconductor substrate into the epitaxial layer enhancing conductivity.

FIG. 20 depicts an embodiment including an N+ semiconductor substrate 200, a P doped epitaxial layer 202, a low side trench conductor 204 within the substrate trench, and a high side trench conductor 205 within the substrate trench. In this embodiment, the etch which forms the substrate trench stops within the epitaxial layer 202. To enhance conduction between the N+ semiconductor substrate and the trench conductor, the epitaxial layer at the bottom of the trench is implanted to an N+ doping level, for example with phosphorus. The implant is then diffused to form a low side trench implant region 206 and a high side trench implant region 207 which extends from the bottom of the trench to the semiconductor substrate 200. In processes having, for example, a trench etch which requires a high aspect ratio, or to simplify the process by using a shallower trench etch which does not require etching down to the level of the semiconductor substrate 200, the bottom of the substrate trench can be implanted to reduce resistance (increase conduction) between the trench conductor 204, 205 and the semiconductor substrate 200. Thus, an ohmic link from the bottom of trench fill 204 to the N+ substrate 200 can be provided.

It will be understood that a P-channel LDMOS device can be formed using dopant conductivities which are the opposite to those of FIGS. 19 and 20. In general, either an N-channel LDMOS FET or a P-channel LDMOS FET can be formed using any of the methods described herein using the specified dopant conductivities or their opposite conductivities.

Embodiments of the present teachings provide connection to the output of the output stage of the device using a conductive layer on the back side of the semiconductor substrate. Benefits of using the back side of the die to connect with the output node, and benefits of monolithically combining the output stage high side FET and the low side FET on one die, can include: reduced packaging challenges since there is no need to connect the output node on top of the die; reduced cost since there is no need to attach one or more bond wires or copper clips to connect to the output node, which can be accomplished by the present teachings through the use of a standard lead frame and conductive die attach material; interconnecting the low side FET and the high side FET improves performance by eliminating parasitic inductances which can cause ringing, loss in efficiency, reduced reliability, higher temperatures, etc.; and LDMOS devices can be used for higher frequency response than other approaches, since LDMOS devices can achieve low gate charge and improved RDS_{ON}*Charge figures of merit.

An embodiment thus can include a high side LDMOS device with its source connected to the substrate, a low side LDMOS device with its drain connected to the substrate using the same trench on the same wafer. The source of the high side LDMOS device is thus the same node as the drain of the low side device.

Embodiments of the present teachings can use a minimum of six masks, and up to 11 masks, depending on the process. These masks can include the following: 1) mask to form the active region; 2) optional mask to form the P-buried layer regions (which can be isolated from each other across low side and high side devices using the trench); 3) optional mask to form the N-drift regions for both devices, which may not be needed if drift region is only formed in region defined by active; 4) gate layer mask; 5) optional P-body mask, which may not be needed in a local oxidation of silicon (LOCOS) process, which can use the field oxide and gate layers to block the implant; 6) optional N+ mask which may not be needed in a LOCOS process, which would use the field oxide and gate layers to block the implant; 7) a body contact mask; 8) a drain contact mask; 9) a deep trench etch mask; 10) a metal mask, and; 11) an optional pad (passivation) mask.

An exemplary 11 mask process is depicted in FIGS. 21-33. Optional masks and process variations will be described such that processes using a different number of masks can be implemented by one of ordinary skill in the art from the description herein.

FIG. 21 depicts a first stage in a process which can be used to form a low side FET 210 and a high side FET 212. The FIG. 21 structure includes an N+ semiconductor substrate 34 and an N-type epitaxial layer 36 which can be formed according to the techniques described above. A patterned first mask 214 (active mask) can be used to pattern a dielectric layer 216, for example silicon nitride. After dielectric layer 216 is patterned, first mask 214 can be removed and the epitaxial layer 38 is oxidized at exposed locations to form field oxide 218 at non-active area locations, for example using a LOCOS process. It should be noted that first mask 214 will typically be removed prior to oxidation of the epitaxial layer 38 to form field oxide 218, however both field oxide 218 and first mask 214 are depicted in FIG. 21 for purposes of explanation.

The first mask 214 which defines the active area is optional. If used, the field oxide 218 will be formed at future N-drift regions of the low side FET 210 and the high side FET 212. The field oxide can improve isolation between devices and can reduce mask count as described below. However, the field oxide can result in an uneven surface which can lead to processing complexities as known in the art. The method described below continues for a device where the active area mask is not used during processing.

After defining the active regions, a patterned second mask 220 (P-buried layer mask) can be formed to define separate P-buried layer regions for the low side device 210 and the high side device 212. A P-type implant is performed to form a P-buried layer 222 for the low side FET 210 and a P-buried layer 224 for the high side FET 212. The same implant can be used to form both P-buried layers 222, 224.

In an alternate embodiment, the second mask is omitted and a blanket P-buried layer implant can be performed to form a continuous P-buried layer over within the epitaxial layer 38. The PBL blanket implant may be sufficient if the P-buried layers 38, 62 for the low side FET 210 and the high side FET 212 are sufficiently separated by a substrate trench etch or a sinker implant (described below). If the sinker implant does not counterdope the P-buried layer sufficiently, the second patterned mask 220 can be used to form discontinuous P-buried layers 222, 224 as depicted.

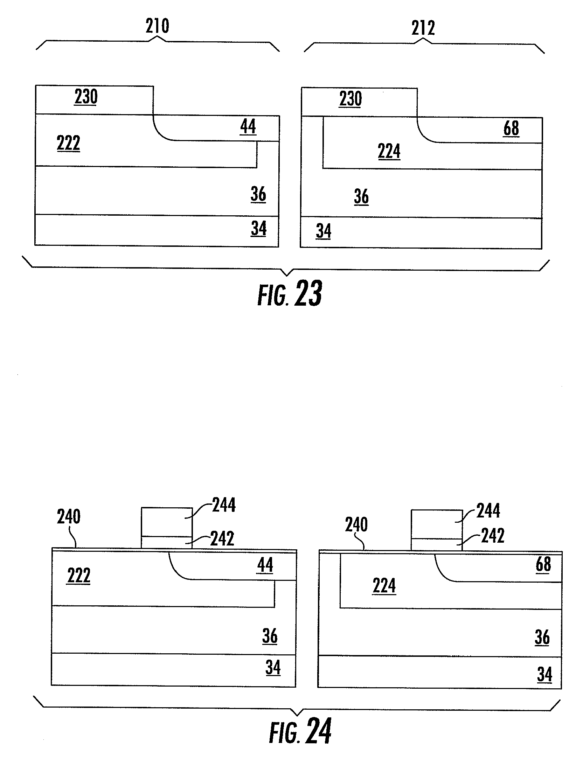

Next, as depicted in FIG. 23, a patterned third mask 230 (N-drift mask) is formed to define the N-drift regions 44, 68. In an alternate process, this mask is omitted and a blanket N-drift implant is performed into the upper surface of the epitaxial layer 36. In the blanket N-drift embodiment, a portion of the N-type region will be sufficiently counterdoped with the P-type P-body implant, such that the P-body region has a net P-type conductivity and thus, the N-drift mask can be omitted.

The FIG. 24 structure includes a gate dielectric 240, patterned transistor gates 242 for the low side FET 210 and the high side FET 212, and a patterned fourth mask 244 (gate mask). To form the FIG. 24 structure, a blanket gate dielectric, a blanket gate layer, and a patterned fourth mask are formed on the FIG. 23 structure. The blanket gate layer is patterned using the forth mask to result in the FIG. 24 structure.

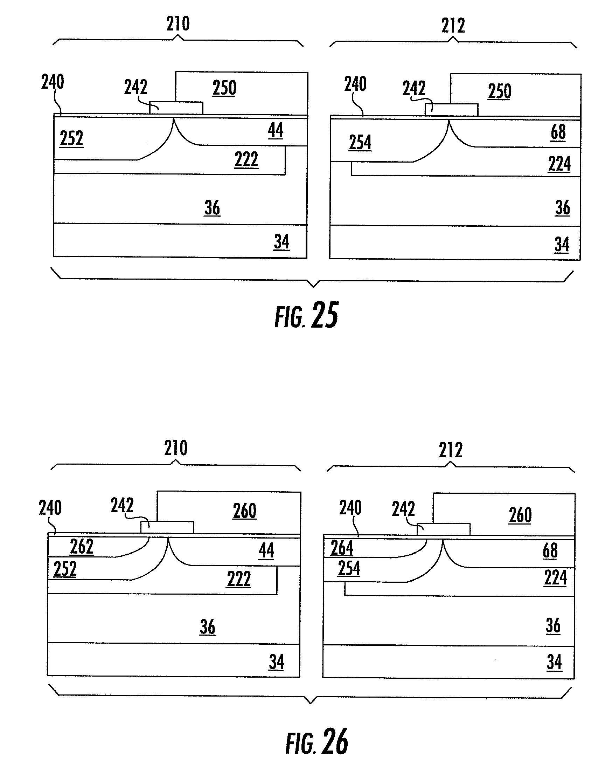

Next, the fourth mask 244 is removed and a patterned fifth mask 250 (P-body mask) is formed over the low side FET 210 and the high side FET 212 as depicted in FIG. 25. A P-type implant is performed to result in low side FET P-body region 252 and high side FET P-body region 254. If the N-drift region was formed as a blanket region, this P-body implant will counterdope the N-drift region. This fifth mask 250 can use a portion of the gates 242 to block the implant and thus, has some processing leeway. After implanting P-body regions 252, the fifth mask 250 is removed an a diffusion process can be performed to diffuse the P-body regions 252, 254 under the transistor gates 242. The P-body mask 250 is optional, and may not needed if the field oxide 218 of FIG. 21 is used which, along with the transistor gates, will block the P-body implant from the N-drift regions.

Subsequently, a patterned sixth mask 260 (source mask) can be formed as depicted in FIG 26 to define the N+ source regions for both devices. An N-type implant provides a source region 262 for the low side FET 210 and a source region 264 for the high side FET 212. The source mask 260 is optional, and may not needed if the field oxide 218 of FIG. 21 is used which, along with the transistor gates, will block the source implant from the N-drift regions. After implanting the source regions 262, 264, the sixth mask 260 is removed.

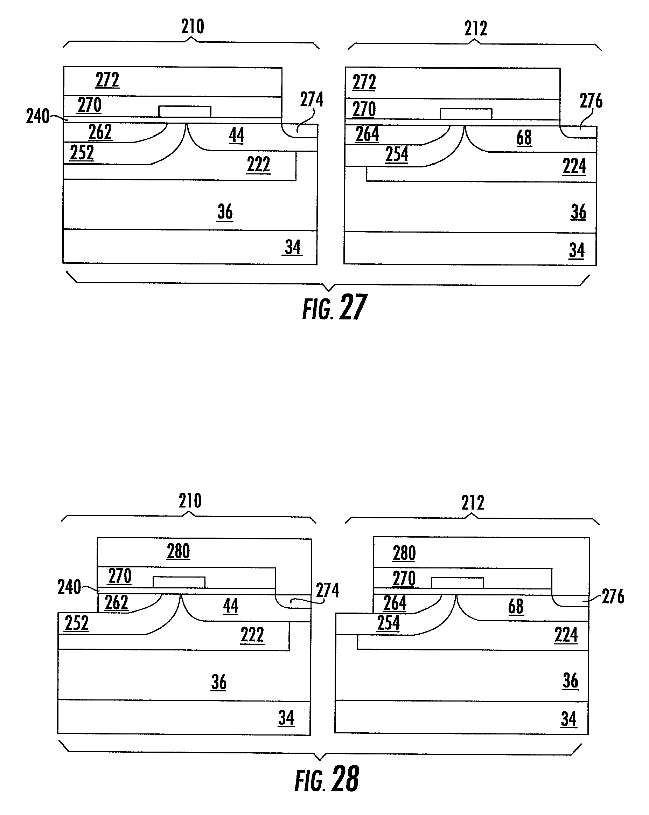

Next, as depicted in FIG. 27, a blanket interlevel dielectric (ILD) layer 270 is formed, and a patterned seventh mask 272 (drain region or drain contact mask) is formed. Exposed portions of the ILD layer 270 and the gate dielectric 240 are etched to expose a portion of the N-drift regions 44, 68. An N+ implant into the N-drift regions 44, 68 is performed to provide low side FET drain region 274 and high side FET drain region 276. After implanting the N+ drain regions 274, 276, the seventh mask 272 is removed.

Subsequently, a patterned eighth mask 280 (body contact mask) is formed as depicted in FIG. 28 which will define contact openings to P-body regions 252, 254, and will expose source regions 262, 264. After forming body contact mask 280, exposed portions of the ILD layer 270, the gate dielectric 240, and the source regions 262, 264 are etched to expose the P-body regions 252, 254. The etch forms vertically oriented sidewalls of the source regions 262, 264 as depicted. The etch may continue to etch slightly into the P-body regions 252, 254. Additionally, a P-type implant can be performed in the case that an under etch fails to expose the P-body regions 252, 254, which will ensure P-type contact to the P-body regions 252, 254. After exposing the P-body regions 252, 254, the eighth mask 280 is removed.

It will be apparent that the order of the P-body contact mask 280 and the drain region mask 270 can be reversed.

After removing the eighth mask, a self-aligned silicide (salicide) process is performed according to techniques known in the art to result in silicide structures 290, 292, 294, 296. Silicide 290 is formed to electrically connect the P-body region 252 to the source region 262 of the low side FET 210, and silicide 292 contacts the drain region 274 of the low side FET 210. Silicide 294 is formed to electrically connect the P-body region 254 of the high side FET 212 to the source region of the high side FET 212, and silicide 296 contacts the drain region 276 of the high side FET 212.

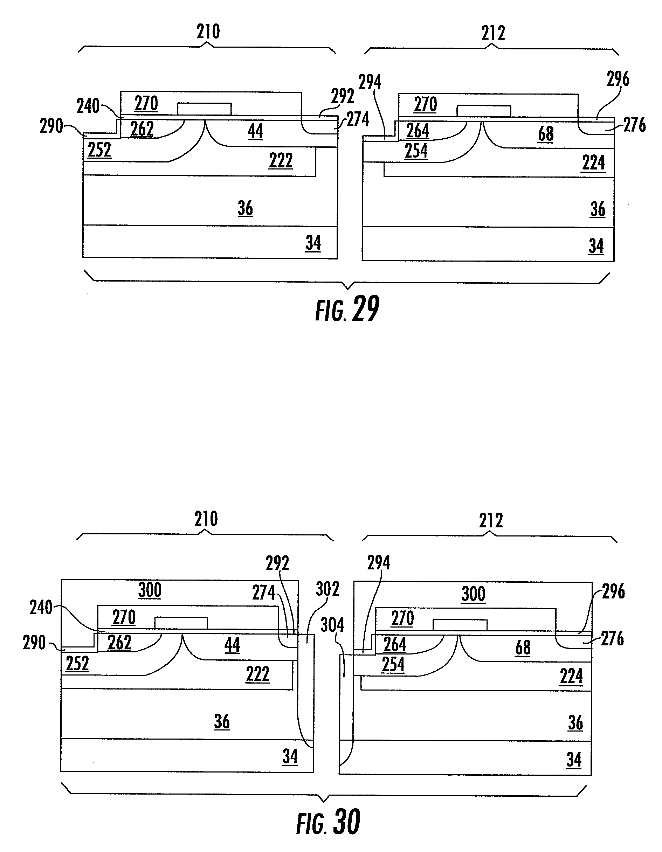

Subsequently, a patterned ninth mask 300 (sinker mask) is formed as depicted in FIG. 30. A silicide etch is performed to etch any exposed salicide 292, 294, then an N+ implant is performed as depicted to form an N+ implanted (doped) sinker region 302 for the low side FET 210 and an N+ implanted (doped) sinker region 304 for the high side FET 212. Sinker region 302 electrically couples the low side FET 210 drain region 274 with the N+ semiconductor substrate 34. Sinker region 304 electrically couples the high side FET 212 source region 264 and P-body region 254 with the N+ semiconductor substrate 34. Thus, the drain region 274 of the low side FET 210 is electrically coupled with the source region 264 of the high side FET 212 through the sinker regions 302, 304, the semiconductor substrate 34, and the silicide 294. After etching exposed silicide 292, 294 and implanting sinker regions 302, 304, the sinker mask 300 is removed.

The silicide 294 further electrically couples the source region 264 to the P-body region 254.It will be realized that the sinker 304 may diffuse under silicide 294 during subsequent processing, which will enhance conduction between both the high side FET source region 264 and the P-body region 264 with the sinker region 304 due to a larger contact surface area. However, the diffusion of region 304 should not extend beyond the sidewall of source region 264 so that contact between the high side FET P-body region 254 and the sinker 304 can be maintained.

Additionally, the sinker regions 302, 304 can have a different profile and/or a different scale than the embodiment depicted in FIG. 30.

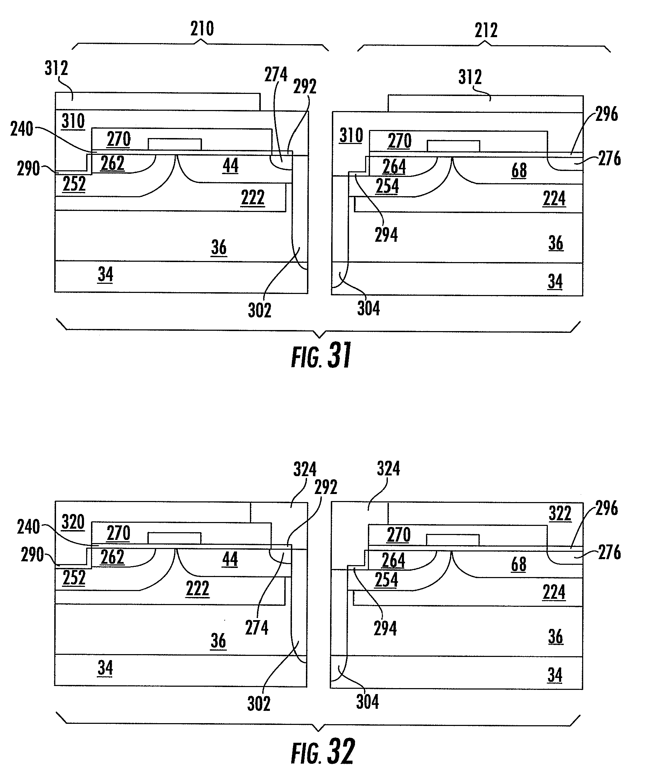

After forming the FIG. 30 structure and removing sinker mask 300, a blanket metal layer 310 and a patterned tenth mask 312 (metal mask) can be formed as depicted in FIG. 31. In particular, the metal layer 310 contacts silicide 290 to make electrical contact with the low side FET source 262 and P-body region 252, and with silicide 296 to make electrical contact with the high side drain 276. After forming the FIG. 31 structure, an etch is performed to remove exposed portions of the metal layer 310, in particular the portion of metal layer 310 over the sinker region 302, 304, while leaving silicide 292, 294. Subsequently, the patterned tenth mask 312 is removed.

The etch of metal layer 310 results in a first metal layer portion 320 which contacts the low side FET 210 source region 262 and P-body region 252, and a second metal layer portion 322 which contacts the high side FET 212 drain region 276 as depicted in FIG. 32. After removing the metal mask 312 of FIG. 32, a blanket dielectric layer is formed and planarized, for example using CMP, to result in dielectric 324 as depicted in FIG. 32.

After forming the FIG. 32 structure, a passivation layer can be formed an patterned using a patterned eleventh mask in accordance with known techniques. Because passivation layers are well known in the art, and because the area depicted in FIG. 32 will typically be clear of any passivation, the passivation layer and mask is not depicted.

By reviewing the process depicted in FIGS. 21-32 and the accompanying text, it will be appreciated that a six mask flow embodiment can include the following mask layers:

1) A mask to form the active region. This mask will be used to pattern a layer of silicon nitride. P-buried layer regions will be created using an MeV implant. Alternately, the P-buried layer can be created using a blanket implant prior to forming the first mask, or the P-buried layer can be created using an epitaxial layer deposition. N-drift regions for both devices are implanted in the region opened using active mask. Thick oxide is grown in the region where nitride is removed using active mask.

2) A gate layer mask. The gate metal (or polysilicon) is patterned using this mask. The P-body region is implanted using a low energy implant. No mask is needed as field oxide and gate layers will block the P-body implant from appropriate regions. An N+ layer is implanted using a low energy implant. Again, no mask is needed as field oxide and gate layers will block the implant in appropriate regions. Oxide is deposited to cover the gate metal.

3) A body contact mask is used to open the region where the body contact will be formed. Oxide, as well as silicon, is etched in the exposed region. The depth of the silicon etch is larger than the N+ junction depth. N+ is exposed on the sidewall, and the P-body region is exposed on the bottom of body contact. An optional P+ implant can be performed to increase the doping of the bottom P-region.

4) A drain contact mask is used to open the region for a drain contact. An N+ implant is performed, and an optional silicide process can be used to create metal silicide in body contact and drain contact regions.

5) A deep trench etch mask is used to open a deep trench from the top surface to below the heavily doped N-region. This trench should be deeper than the P-buried layer, and is preferably more than the combined thickness of all epitaxial layers. The order of the drain contact mask and the deep trench etch mask can be varied.

6) A metal mask is then used to pattern subsequent metallization.

It is also contemplated that a process which does not use a mask to form the active layer can be used. This process will have improved performance, but may require additional layers. In this process, a minimum of 8 and a maximum of 10 masks can be specified. The masks for a process without active can include: 1) an optional mask to implant the P-body regions, which may not be needed as the P-body regions can be isolated from each other using the trench; 2) a mask to define the N-drift regions; 3) a mask to define the gates; 4) a mask to expose the P-body regions; 5) a mask to define the N+ regions for the source and drain contacts; 6) a mask to etch the P-body region; 7) a mask to form the drain contacts; 8) a mask for the trench; 9) a mask for the metal, and; 10) an optional pad (passivation) mask.

Further, in some embodiments, a mask to form the P-buried layer may be omitted because both the low side and high side devices include the P-buried layer. A P-well created during the formation of the P-buried layer can be separated during the trench etch to support isolated operation of the two devices. In an embodiment, the P-buried layer can be a separate epitaxial layer, thus, omitting the need for a high energy implant.

A high side LDMOS device and a low side LDMOS device can be formed on a single semiconductor die to provide a PowerDie. In an embodiment, the PowerDie can be packaged or encased together with a separate semiconductor die including voltage converter controller circuitry which is electrically coupled with the PowerDie to provide a DC to DC converter. Thus, the PowerDie with the low side transistor and the high side transistor are located in the same device package as the controller circuitry.

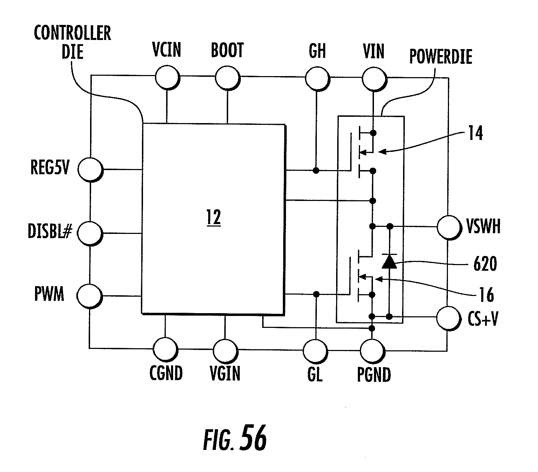

The embodiments described below depict embodiments including a DC to DC converter, and further including a Schottky diode. The schematic embodiment of FIG. 2, for example, further including a Schottky diode 620 integrated with the low side FET 16 to provide Schottky diode protection for the circuit is depicted in FIG. 56. Integrating the Schottky diode with the low side FET 16 as described below can provide various advantages over an external Schottky diode. For example, integrating the Schottky diode with the low side FET can result in a device which can have lower reverse recovery losses, resulting in substantially improved efficiency at a high switching frequencies (for example, greater than 700 kHz). Further, a device according to the present teachings can have reduced or no inductance between the low side FET and the integrated Schottky diode. This is advantageous particularly for devices operating at a switching frequency of 700 KHz or more.

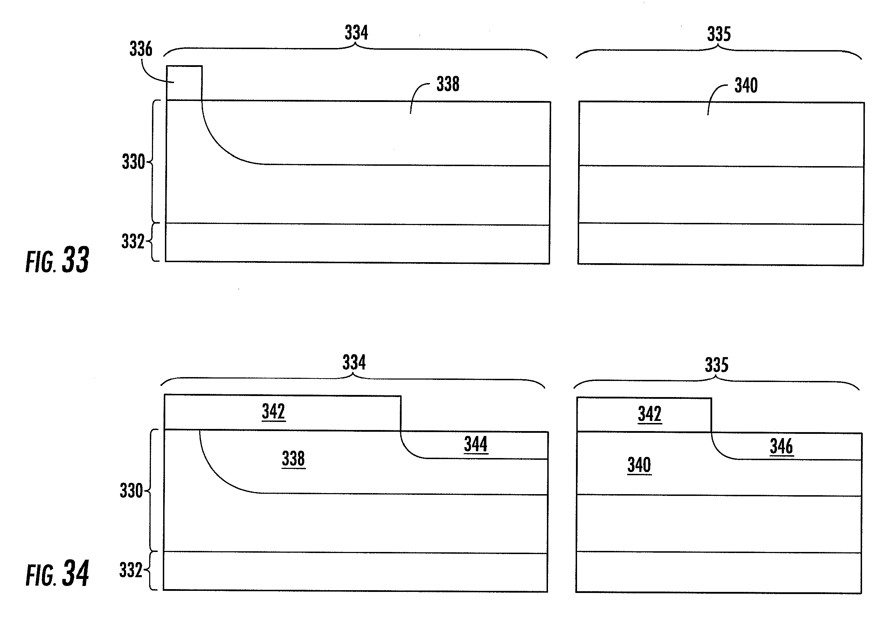

FIGS. 33-52 depict an embodiment of the present teachings to form a power converter such as a DC to DC power converter in accordance with previous embodiments, and further including an integrated Schottky diode. The embodiment of FIGS. 33-52 can include a semiconductor die having a front side and a back side. The semiconductor die can include a die substrate, which can include an N-type epitaxial layer 330 and an N+ semiconductor substrate 332 as depicted in FIG. 33. The N-type epitaxial layer 330 can have a dopant concentration of about 1 E14 to about 1 E18 atoms/cm³, while the N+ semiconductor substrate 332 can have a dopant concentration of about 1 E18 to about 1 E20 atoms/cm³. The dopant concentration of the semiconductor substrate 332 will be greater than the epitaxial layer 330. For this embodiment, a low side FET 334 will be formed on the left side of FIG. 33, and a high side FET 335 will be formed on the right side of FIG. 33.

A P-buried layer mask 336 is formed, and a masked high-energy P-type implant is performed into the N-type epitaxial layer 330 to form a patterned P-buried layer including P-buried layer 338 for the low side FET 334 and P-buried layer 340 for the high side FET 335. The PBL 338, 340 can have a net maximum concentration of P-type dopants in the range of about 1 E 15 to 1 E 19 atoms/cm³. An alternate embodiment can start with an N+ substrate, followed by a masked P-type implant to form a P-buried layer, followed by a growth of an N-type epitaxial layer to result in a structure similar to that depicted in FIG. 33 having similar dopant concentrations. This alternate sequence would result in the P buried layer imbedded in the N+ substrate with up diffusion into the overlying N epitaxial layer.

N-type substrates can be doped with high levels of antimony, arsenic or phosphorus (or combinations), or red phosphorus, which results in even higher concentration of N-type dopants for lower resistivity. Resistivity can be about 10 milliohm-cm (mΩ-cm) for antimony, about 2 mΩ-cm for arsenic, and about 1 mΩ-cm for red phosphorus.

Next, active regions can be formed using a LOCOS process in a manner similar to that described with reference to FIG. 21. This embodiment, however, will continue without the use of LOCOS. Accordingly, an N-drift mask 342 is formed and N-drift regions 344, 346 are implanted into the low side FET 334 and the high side FET 335 respectively as depicted in FIG. 34. The N-drift regions 344, 346 can have a net maximum dopant concentration in the range of about 1 E14 to about 1 E18 atoms/cm³.

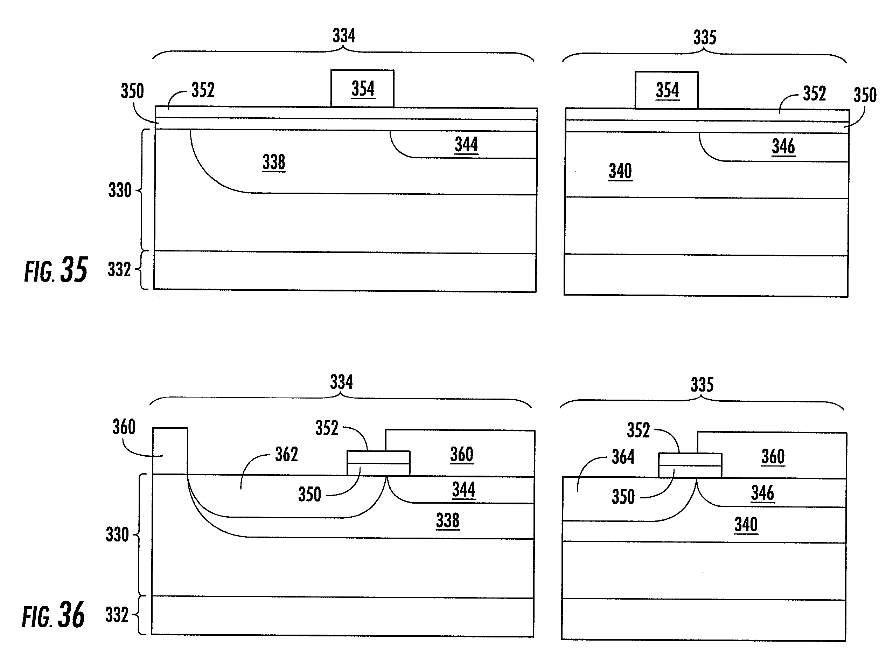

After forming N-drift regions 344, 346, a blanket gate dielectric layer 350 such as gate oxide can be grown or deposited, then a blanket transistor gate layer 352 such as gate metal, or a doped or undoped gate polysilicon and/or gate polycide can be formed as depicted in FIG. 35. A gate mask 354 is formed, then the blanket transistor gate layer 352 and the blanket gate dielectric layer 350 are etched to define transistor gates 352 and gate dielectric 350 on the circuit side of the semiconductor die as depicted in FIG. 36.

Next, a P-body mask 360 can be formed, and a P-type implant can be performed into the N-type epitaxial layer 330 to provide implanted P-body regions 362, 364 for the low side FET 334 and the high side FET 335 respectively. The P-body regions 362, 364 are formed within the P-buried layer 338, 340 respectively, and can have a net maximum P-type dopant concentration in the range of about 1E16 to about 1E18 atoms/cm³. A diffusion can be performed to diffuse implanted regions 344, 346, 362, 364 under gates 352 as depicted in FIG. 36. If performed, the diffusion will typically be completed after removing P-body mask 360, which remains in the FIG. 36 depiction for simplicity of explanation.

In this embodiment, the left edge (referring to FIG. 36) of P-body region 362 for the low side FET 334 is generally aligned with the left edge of P-buried layer 338. In other words, the boundary of P-body region 362 at an edge which is away from the gate 352 is targeted to intersect a boundary of the P-buried layer 338 at the surface of the N-epitaxial layer 330 subsequent to any diffusion.

As previously described for other embodiments, the P-buried layers 338, 340, can be implanted simultaneously to provide a single implanted region for both the low side FET 334 and the high side FET 335, as can the N-drift regions 344, 346, the transistor gates 352 and the P-body regions 362, 364. It will be realized that the order of creating the gates 352 and P-body regions 362, 364, as well as other processing stages, can be interchanged.

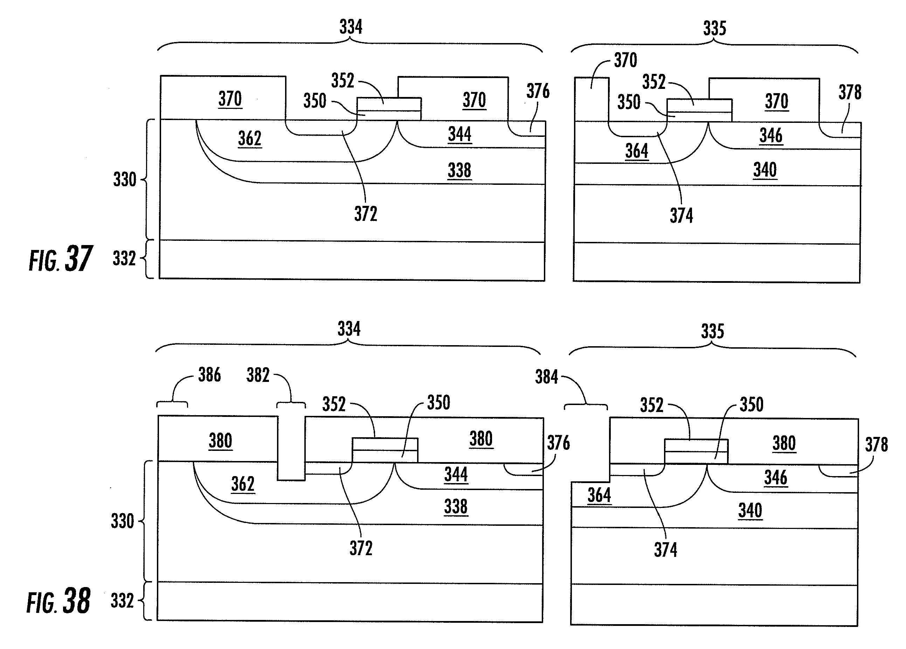

After forming the structure of FIG. 36 and removing P-body mask 360, a source/drain mask 370 can be formed as depicted in FIG. 37. An N+ implant forms N+ source regions 372, 374 nested within P-body regions 362 and 364 respectively, and form N+ drain regions 376, 378 nested within N-drift regions 344, 346 respectively. An N+ dopant implant, typically arsenic, can be performed to a net maximum dopant concentration in the range of about 1E18 to about 5E20 atoms/cm³.

Subsequently, a body contact mask 380 as depicted in FIG. 38 can be formed to expose edges of source regions 372, 374 of FIG. 37. An etch of the N-epitaxial layer 330 is performed to remove a portion of the source regions 372, 374, and to just expose P-body regions 362, 364 as depicted in FIG. 38. The etch recesses the N-epitaxial layer 330 to form a low side FET 334 P-body contact region 382 and a high side FET 335 P-body contact region 384. That is, the depths of recesses which form P-body contact regions 382, 384 extend beyond a lower extent of the N+ doped silicon which forms source regions 372, 374. To ensure P-type contact to the P-body regions 362, 364 in the case of an under etch, a P-type implant can be performed with the P-body mask 380 in place, for example to protect a Schottky diode region 386 of the epitaxial layer 330 within which the Schottky diode will be provided. After forming a structure similar to FIG. 38, P-body mask 380 can be removed.

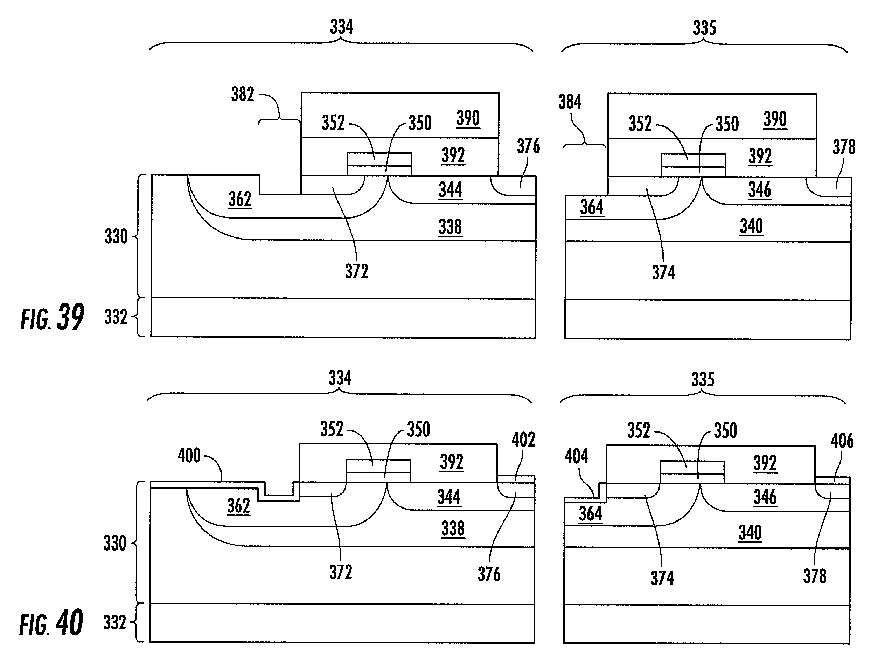

A blanket interlevel dielectric (ILD) layer can be formed, for example from an oxide, followed by an ILD mask 390. The blanket ILD layer is etched using an etch selective to silicon which results in the structure of FIG. 39, including patterned ILD layer 392. Patterned ILD layer 392 covers the gates 352, while the drain regions 376, 378, the P-body contact regions 382, 384 to the P-body regions 362, 364, and a portion of the N-type epitaxial layer 330 remains uncovered as depicted. After removing the ILD mask 390, an N+ diffusion process can be performed to diffuse the N+ sources 372, 374 under the gates 352 as depicted in FIG. 39. The N+ diffusion can also be used to densify the ILD layer 392. Optionally, the N+ diffusion can be performed prior to depositing the blanket ILD layer.

After removing the ILD mask 390 and performing the N+ diffusion, a salicide (self-aligned silicide) process can be performed to result in silicide structures 400, 402, 404, and 406 as depicted in FIG. 40. A salicide process can include the blanket deposition of a metal layer, such as titanium metal, cobalt metal, or another silicide-forming layer, for example using chemical vapor deposition (CVD) or sputtering, followed by an anneal stage to react the metal layer with silicon where metal-to-silicon contact is made. This results in a self-aligned low-resistance silicide layer including portions 400, 402, 404, and 406 over the exposed silicon. Any unreacted portions of the metal layer are stripped to result in a structure similar to that of FIG. 40.

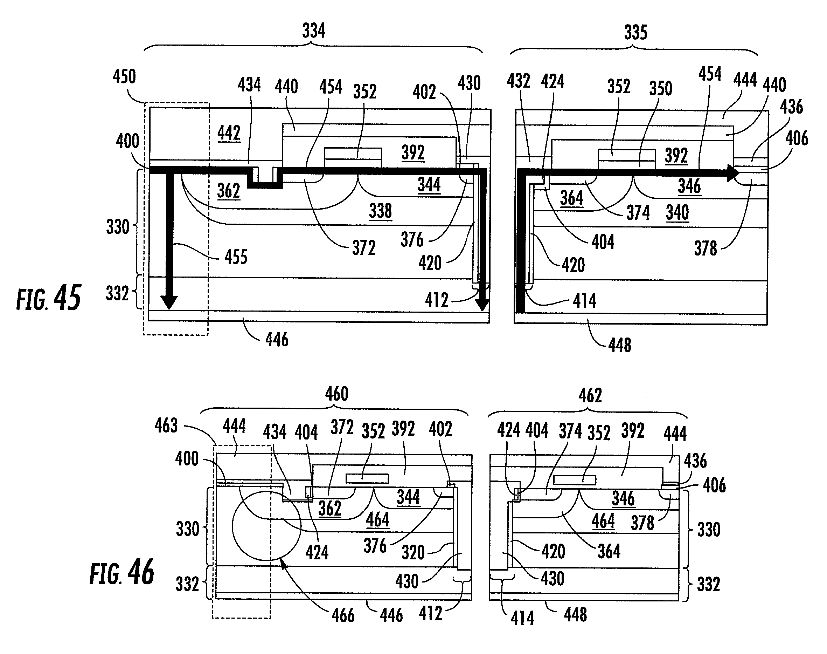

The silicide layer 400 contacting the P-body region 362 of the low side FET 334 electrically connects the low side FET source region 372 and P-body region 362 together. This silicide layer 400 also contacts epitaxial layer 330 such that a Schottky diode (450 in FIG. 45) for the low side FET 334 includes the electrical contact between the layers as described below. The silicide layer 404 covering the P-body region 364 of the high side FET 335 electrically connects the high side FET source region 374 and P-body region 364 together. Silicide layer 402, 406 covers the exposed N+ drain regions 376, 378 respectively to provide low resistance drain contacts using a subsequent conductive layer.

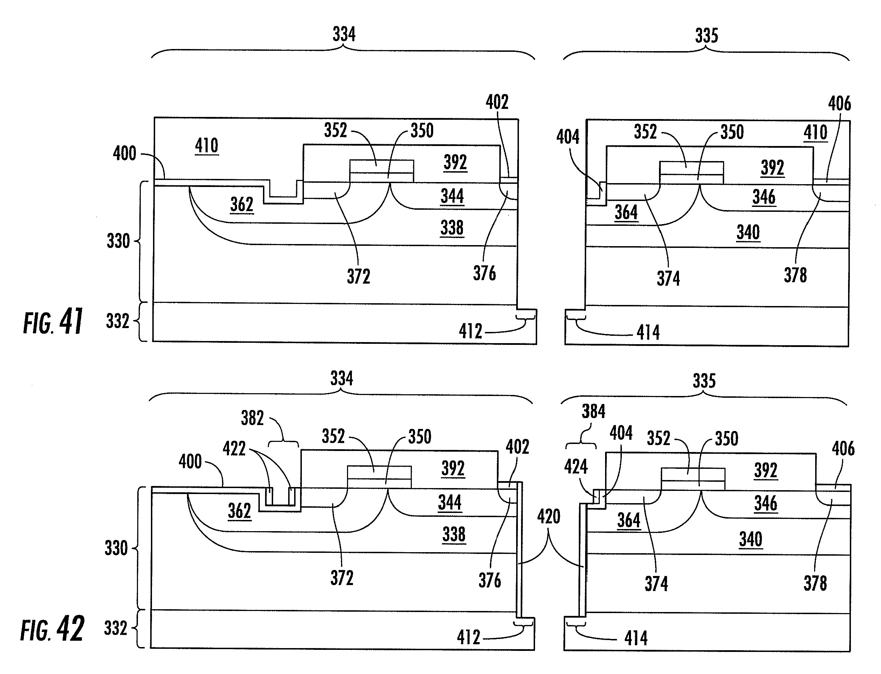

Next, a substrate trench mask 410 can be formed to expose one or more regions at the drain region 376 of the low side device 334 and the source region 374 of the high side device 334 as depicted in FIG. 41. The substrate trench etch is sufficiently deep to extend lower than the N-type epitaxial layer 330 and to extend into and expose the N+ semiconductor substrate 332. A low side substrate trench 412 and a high side substrate trench 414 are depicted in FIG. 41. These substrate trenches are numbered differently to emphasize that they can be different trenches at different locations of the semiconductor substrate 332 and epitaxial layer 330, or may be a single trench between the two FETs as previously described.

Next, a blanket conformal layer, such as an oxide to a thickness of about 200 A to about 5,000 A, for example about 1,000 A, can be formed, followed by an anisotropic (spacer) etch. This will provide dielectric spacers over vertical surfaces, including spacers 420 over the vertically oriented sidewalls of the substrate trenches 412, 414, and spacers 422, 424 over the exposed silicide layer at sidewalls of openings 382, 384 respectively.

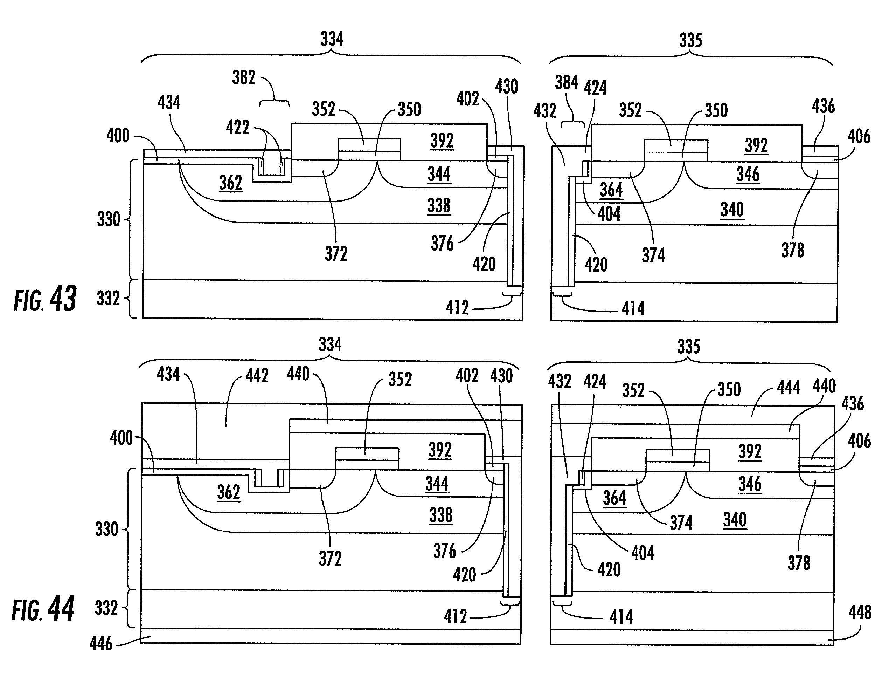

Next, a conductive layer is formed to fill the P-body contact regions 382, 384 depicted and to fill the substrate trenches 412, 414. The conductive layer can be a tungsten layer, or may be polysilicon which is *in situ* doped to an N+ conductivity, for example with arsenic or phosphorous to minimize resistance. An etch of the conductive layer is performed to recess the conductive layer to result in a low side substrate trench conductor 430, a high side substrate trench conductor 432, a low side source electrode 434, and a high side drain electrode 436 as depicted in FIG. 43. While, in one embodiment, low side substrate trench conductor 430 and high side substrate trench conductor 432 may be formed in different trenches and do not physically contact each other, they may be electrically connected together through the N+ semiconductor substrate 332. Other circuitry may be formed on and/or within the semiconductor substrate 332 and/or epitaxial layer 330 at a location between the low side FET 334 and the high side FET 335.

Next, one or more dielectric layers can be deposited and patterned to form dielectric 440 over the gate 352 and the substrate trench conductor 430 of the low side FET 334, and over the gate 352 and the substrate trench conductor 432 of the high side FET 335 as depicted in FIG. 44. The dielectric 440 can include, for example, one or more of low temperature oxide (LTO) with borophosphosilicate glass (BPSG), or LTO with phosphosilicate glass (PSG). The dielectric layer 440 can be planarized prior to patterning, for example using BPSG flow, chemical mechanical polishing (CMP), planarization etchback, etc. Patterned dielectric layer 440 with a contact mask can leave the low side FET source electrode 434 and the high side drain electrode 436 exposed.

Following this, a metal layer 442, 444 is formed, for example using a standard tungsten plug process or an aluminum (AlCu for example). Conductive layer 442 provides a source contact to both the N+ source region 372 and the P-body region 362 of the low side FET 334. Contact between the conductive layer 442 and the N+ source region 372 of the low side FET 334 may be through silicide layer 400 and conductive layer 434. Conductive layer 434 is part of the conductive layer which forms the substrate trench conductor 430, 432. Conductive layer 444 provides a drain contact to the N+ drain region 378 of the high side FET 335. Contact between the conductive layer 444 and the N+ drain region 378 of the high side FET 335 may be through silicide layer 406 and conductive layer 436. Conductive layer 436 is part of the conductive layer which forms the substrate trench conductor 430, 433.

Conductive layer 442 can be electrically connected with a bond wire and a device pinout to P_{GND}, while conductive layer 444 can be electrically connected with a bond wire and a device pinout to V_{IN}. Additionally, while conductive layers 442, 444 may be formed during a single metal process, they are electrically isolated from each other.

To complete the FIG. 44 structure, a back side (i.e., non-circuit side) conductive layer such as a metal is formed to provide back side conductive layers 446, 448. Layer 446, 448 can provide a drain contact to the drain 376 of the low side FET 334 and a source contact to the source 374 of the high side FET 335. The back side conductive layers can be formed during the process which forms conductive layers 442, 444. While conductive layers 446, 448 may be formed during a single metal process, for example, it may or may not be a continuous metal across a back side (non-circuit side) of the semiconductor substrate 332. Even if the conductive layers 446, 448 are not a single continuous structure across the back side of the semiconductor substrate 332, the conductive layers 446, 448 may be electrically connected together through the N+ semiconductor substrate 332 to which they are both connected through physical contact.

With the embodiment of FIG. 44, the low side source electrode 434 electrically contacts the silicide layer 400 on the sidewall of the source region 372 of the low side FET 334. Also for the low side FET 334, the trench conductor 430 connects the N+ drain region 376 through silicide layer 402 to the N+ semiconductor substrate 332.

Additionally, on the high side FET 335, the N+ source region 374 is electrically shorted through silicide layer 404 to the P-body region 364. This is in turn shorted to the silicon substrate 332 through the trench conductor 432.

Conductive layer 442 electrically contacts the N+ source region 372 of the low side LDMOS device 334. This conductive layer 442 can form a pad exposed at the top surface of the FIG. 44 structure which, in most power converter applications, can be connected to device ground (P_{GND}). This connection can be made through a bond wire which connects to a lead frame pinout, which is adapted to be connected to P_{GND}.

Conductive layer 444 contacts the N+ drain region 378 of the high side LDMOS device 335. Conductive layer 444 can form a pad exposed at the top surface of the FIG. 44 structure to allow for wire bonding or other interconnection techniques. For example a wire bond can connect conductive layer 444 to a device pinout, which is adapted to be connected to device voltage in (V_{IN}) during operation of the power MOSFET device.

FIG. 45 depicts various aspects of the present embodiment. A Schottky diode 450 is provided between conductive layer 400 and conductive layer 446. As discussed above, conductive layer 434 can provide a source electrode for the source 372 of the low side FET 334. Additionally, source electrode 434 can function as a Schottky diode anode. The back side conductive layer 446 can provide a drain contact to the drain 376 of the low side FET 334, and can function as a Schottky diode cathode contact. The Schottky diode cathode can be formed by N-type epitaxial layer 330 which makes ohmic connection to N+ substrate 332.

The Schottky diode 450 of FIG. 45 provides both Schottky protection and Schottky junction FET (JFET) protection. Schottky protection includes contact between metal layer 400 and N-epitaxial layer 330. Without being bound by theory, the Schottky protection protects the device from excessive minority carriers in the epitaxial layer 330 when the device is in conduction mode. Excessive carriers can lead to significant reverse recovery losses and result in failures. Schottky JFET protection includes a junction between the N-epitaxial layer 330 and the P-body region 362, as well as the interface between the P-body region 362 and the PBL 338, at a location near or within the Schottky diode 450. When a positive voltage with respect to layer 400 is applied to back side conductor 446, 448, a depletion layer is created across the junction of P-buried layer 338 and N-epitaxial layer 330. At a sufficiently high voltage, the entire N-epitaxial layer region 330 that is directly underneath the silicide layer 400 within the Schottky diode 450 becomes depleted, and an electric field at an interface (junction) of P-body 362 and N-epitaxial layer 330 stops increasing. This results in Schottky JFET protection of the Schottky diode by the PN junction at the interface of P-body 362 and N-epitaxial layer 330. If the electric field at the junction between silicide structure 400 and N-type epitaxial layer 330 is allowed to increase, excessive leakage can occur which may result in device avalanche failure.

Thus, Schottky protection protects against excessive minority carriers in the epitaxial layer 330 when the device is in diode conduction mode, while Schottky JFET protection protects against high electric field at the Schottky diode interface.

Portions of the epitaxial layer 330 and the semiconductor substrate 332 are interposed between the Schottky diode anode 434 and the Schottky diode cathode contact 446. The N+ drain region 376 of the low side FET 334 is electrically connected to the source region 374 of the high side FET 335 through the substrate trench conductor 430, 432 and the back side conductor 446, 448. The back side conductor 446, 448 can be contacted, for example with a die pad of a lead frame, to provide an output node (phase node) of the DC to DC output stage. In other words, the back side conductor 446, 448 can provide a contact to the output of the output stage of the DC to DC power converter. As the low side FET 334 turns on during switching (i.e., is enabled), electrons flow from the low side source region 372 to the low side drain region 376, to the silicide 402, to trench conductor 430, through the substrate 332, and to the back side conductor 446. This conductive path through both the low side device 334 and the high side device 335 is depicted as 454 in FIG. 45.

The back side conductor 448 can be continuous with back side conductor 446 (i.e., the same electrical point). The N+ source region 374 of the high side FET 335 can be connected to back side conductor 448 through N+ semiconductor substrate 332, substrate trench conductor 432, and silicide layer 424.

Thus, the low side FET 334 is connected to the high side FET 335 through the trench conductors 430, 432 and the N+ substrate 332. The substrate trench conductor 430, 432 is interposed between the p-body region 344 of the low side FET 334 and the p-body region 340 of the high side FET 335. The flow of current through the low side FET 334 when it is enabled (turned on) is depicted by arrow 454, and the flow of current through the high side FET 335 when it is enabled is depicted by arrow 454. The flow of current when the DC to DC converter is enabled is from ground through the source region 372 of the of the low side FET 334, through a low side FET channel within the epitaxial layer 330 under transistor gate 352 to the N+ drain region 376 of the low side device 334, through the silicide 402 and trench conductor 430, through the semiconductor substrate 332 (which is the output node, when the output is connected). Current in the high side device flows from the back of the device 448, to the semiconductor substrate 332 and through the substrate trench conductor 432, through the N+ source region 374 of the high side FET 335, through a high side FET channel within the epitaxial layer 330 under the high side FET 335 transistor gate 352 when enabled and to the N-drift region 346 and N+ drain region 378 of the high side device, then to the silicide 406 and the conductive layer 436 to the conductive layer 444 overlying the high side FET transistor gate 352. Metal 444 can be electrically coupled to device V_{IN}. The converted voltage can be provided by the output node, and the output node can be accessed through the back side metal 446, 448 and the semiconductor substrate 332.

The arrow 455 within Schottky diode 450 depicts the current flow when both the low side FET 334 and the high side FET 335 are off and current is conducting through the Schottky diode 450.

In the embodiment of FIG. 45, the Schottky diode 450 includes contact between conductive layer 400 and the epitaxial layer 330 at a location adjacent to the P-buried layer 338 and the P-body 362 as depicted at Schottky diode 450. As previously discussed, when a positive voltage with respect to layer 400 is applied to back side conductor 446 and 448, a depletion layer is created across a PN junction created by P-body region 362 and N-epitaxial layer 330. At a sufficiently high voltage, for example at about +5 V or higher applied between the back side conductive layer 446 and the conductive layer 442, the entire N-epitaxial layer 330 that is within the Schottky diode 450 directly underneath the Schottky diode anode 434 becomes depleted, and an electric field at an interface of conductive layer 400 and N-epitaxial layer 330 stops increasing. This results in protection of the Schottky diode by the PN junction provided at an interface of the P-body 362 and the N-epitaxial layer 330 within Schottky diode 450.

Various additional embodiments of the present teachings are contemplated and can be formed using methods similar to those described above. Other embodiments are depicted in FIGS. 46-52, and are described below.

FIG. 46 depicts a device including a low side FET 460 and a high side FET 462 having a Schottky diode 463 integrated with the low side FET 460 at the cell level. For purposes of this disclosure, a Schottky diode "integrated at the cell level" is one which is formed on and/or within the semiconductor substrate within and adjacent to a FET such as a low side FET and/or a low side FET for a voltage converter is formed. The Schottky diode may be formed with one or more layers which are common to the one or more FETs, such as one or more deposited conductive layers, one or more silicide layers, and one or more doped layers implanted with one or more common implants.

The Schottky diode 463 includes contact between metal 400 and the N-type epitaxial layer 330. This device also includes Schottky JFET protection which includes the PN junction between N-type region 330 and the P-body region 362 of the low side device 460 only at location 466. This device can be formed by adjusting a P-buried layer mask (such as mask 336 in FIG. 33) which is present during implantation of the P-buried layer 464. In this embodiment, a portion of the P-body region 362 is formed within the P-buried layer 464, an end of the P-body region 362 extends beyond an end of the P-buried layer 464. The PN junction between the P-body region 362 and the N-type epitaxial layer 330 provides JFET protection of the Schottky diode 463. This method and structure can result in a reduced inductance, or no inductance, between the FETs 460, 462 and the Schottky diode. Further, the device does not require fine geometry to form the P-buried layer 464. In other words, the location of the PBL 464 relative to the P-body region 362 is not as critical as, for example, the FIG. 45 device, which requires more precise alignment of the P-body 362 and the P-buried layer 338. This device may have an increased pitch for the FETs, for example resulting from providing a minimum extrusion of P-body region 362 beyond the P-buried layer 464 (similar to region 532 in FIG. 5 which provides spacing between adjacent P-buried layers 338).

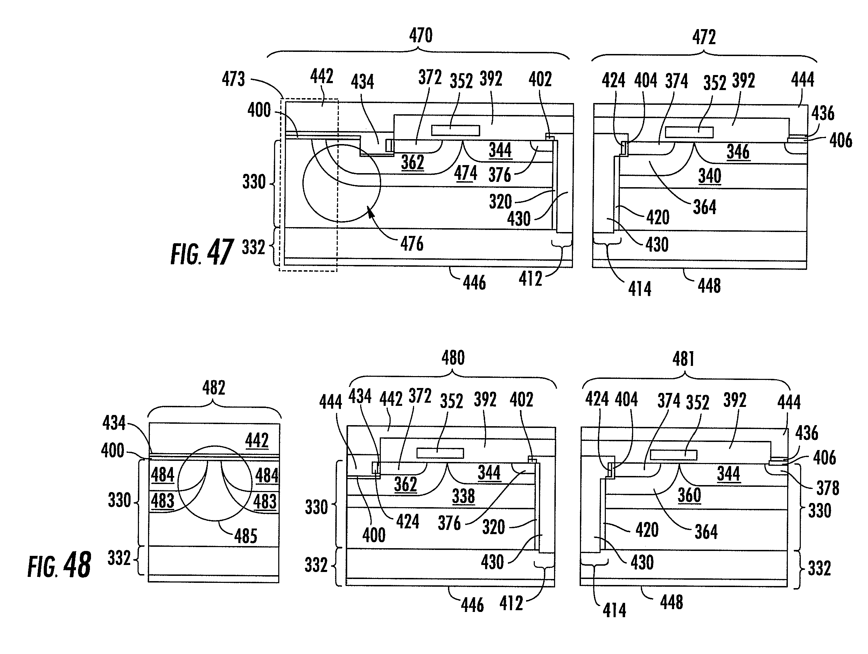

Another embodiment of the present teachings is depicted in FIG. 47, which can provide a low side device 470 and a high side device 472, along with a Schottky diode 473 integrated with the low side FET 470 at the cell level, from contact between metal 400 and N-epitaxial layer 330. To form the FIG. 47 device, the mask which defines the P-buried layer (for example mask 336 of FIG. 33) can be modified to result in a P-buried layer 474 which extends beyond the end of the P-body region 362 of the low side FET 471. This results in P-body region 362 being nested within P-buried layer 474. Additionally, the P-buried layer 474 may be doped to a heavier concentration and diffused to a greater extent than the FIG. 45 device to result in a device similar to that of FIG. 47. Schottky JFET protection of the FIG. 47 device can include a PN junction between the P-buried layer 474 and N-type epitaxial region 330 at location 476. The device can result in decreased inductance, or no inductance, between the FETs 470, 472 and the Schottky diode 473. The Schottky diode 473 may be well protected in this case because JFET protection is provided by PBL 474 which is deeper than the P-body region 362. However, the device may have an increased distance between adjacent low side FETs which can result from the P-buried layer 474 having an increased lateral dimension to extend beyond the low side FET 470 P-body region 362. Further, this device may require fine geometry for the P-buried layer 474, resulting from having to control the mask openings which define the P-buried layer 474 and the P-body 362 relative to each other.

The device of FIG. 48 includes a low side FET 480 and a high side FET 481, and a Schottky diode 482 integrated with the FETs at the die level. Schottky protection includes contact between metal 400 and N-epitaxial layer 330. Schottky JFET protection includes the PN junction between N-type epitaxial layer 330 and P-body region 484, as well as a P-buried layer 483 at location 485. Schottky diode 482 can be at any wafer location and need not be next to the low side FET 480. That is, the P-buried layer 483 and P-body 484 at location 485 does not have to be a part of either the low side FET 480 or the high side FET 481, but can be independent layers implanted during implantation of the PBL 338, 340 and P-body 362, 364 of the low side device 480 and the high side device 481. The Schottky diode 482 can include two PBL regions 483 spaced from each other by the doped region of the epitaxial layer 330 and two and two P-body regions 484 also spaced from each other by the doped region of the epitaxial layer 330. Further, silicide 400 can be formed at a different time and can be a different composition from silicide layer 424 in the FET regions. Thus, each material can be different from the other and selected, for example, from platinum silicide, cobalt silicide, titanium silicide, etc. and customized for the desired electrical characteristics of the device being formed. The Schottky diode 482 can be formed by adjusting the masks used to form the P-buried layer mask (i.e., mask 336 in FIG. 33) and the P-body region mask (i.e., mask 360 in FIG. 36) to form the Schottky diode structure at location 485 depicted at Schottky diode 482. Additionally, metal layers 400, 434, 442 can be the same metal layer or two or more different layers, if desired, at the cost of an additional mask. The FET portion of the device (i.e., FETs 480, 481) can be formed using a process similar to that of previous embodiments, for example the FIG. 45 embodiment, omitting the Schottky device 450 and resulting in the FETs 480, 481 as depicted in FIG. 48. The device may have a higher inductance between the FETs 480, 481 and the Schottky diode 482 than previous embodiments described above. Further, a loss of area due to allocation of semiconductor substrate to the Schottky diode 482 may result in a device having an increased size, or reduced density.

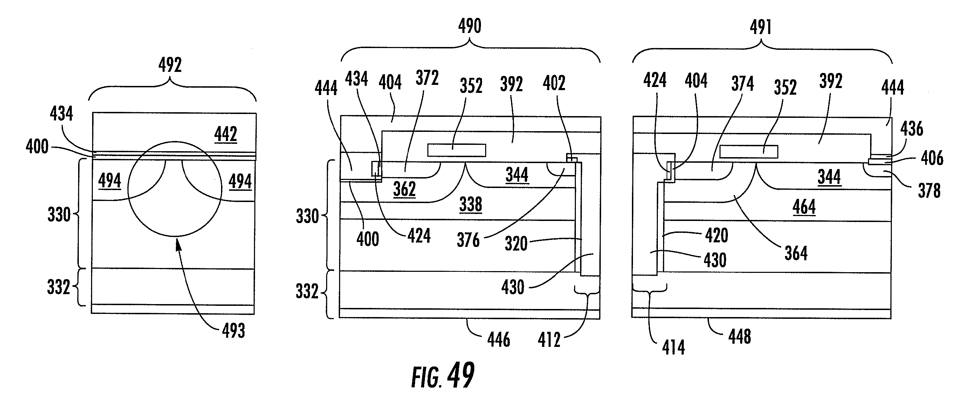

The device of FIG. 49 includes a low side FET 490, a high side FET 491, and a Schottky diode 492 integrated with the FETs 490, 491 at the die level. The Schottky diode 492 includes contact between metal 400 and the N-epitaxial layer 330 at location 493. JFET protection of the Schottky diode includes a PN junction between N-epitaxial layer 330 and P-body region 494 at semiconductor substrate location 492. The Schottky diode 492 can include two P-body regions 494 spaced from each other by the doped region of the epitaxial layer 330. The FETs 490, 491 can be formed using a process similar to that of previous embodiments, for example the FIG. 45 embodiment, omitting the Schottky device 450 and resulting in the FETs 490, 491 as depicted in FIG. 49. The device can use a different Schottky diode metal for the Schottky diode 492 for improved leakage, for example similar to that described with reference to FIG. 48. The device may result in a higher inductance between the FET and the Schottky diode, and a loss of area due to allocation of die area to the Schottky diode can result in a larger device or a device with decreased device density. The P-body regions 494 can be implanted during implantation of P-body regions 362, 364 of the low side FET 490 and the high side FET 491 respectively. P-body regions 494 can be independent of structures 362, 364, and can be formed by adjusting a P-body mask, for example mask 360 in FIG. 36. Metal 400, 434, 442 can be replaced by another metal layer, at the cost of an additional mask. Layer 494 can be formed during the implant of P-body regions 362, 364, or P-buried layer 338, 464, or both, or formed with a separate masked implant.

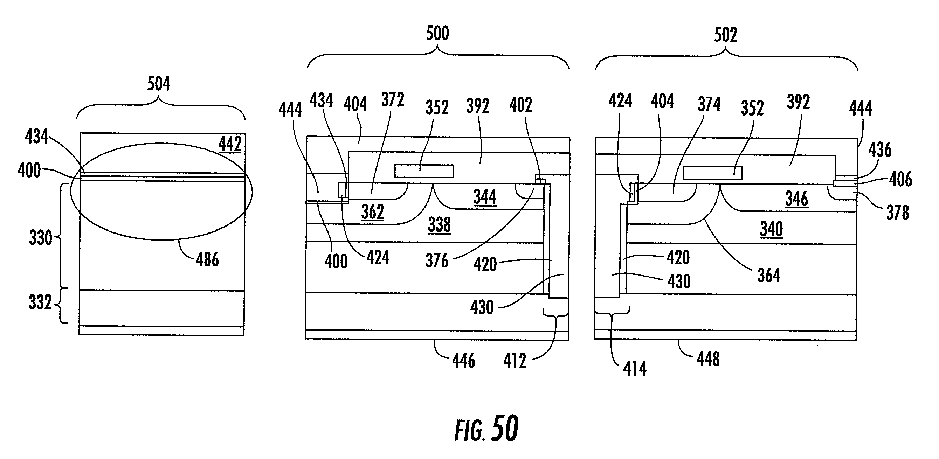

The device of FIG. 50 includes low side FET 500, a high side FET 502, and a Schottky diode 504 integrated with the FETs 500, 502 at the die level. Schottky protection includes contact between metal 400 and N-epitaxial layer 330 at location 504. Because no P-body or P-buried regions are implanted into Schottky diode 504, the Schottky diode 504 is free from a region of the net P-type conductivity and no Schottky JFET protection is provided. This embodiment can be similar to the FIG. 49 embodiment, with the P-body implant omitted from the Schottky diode 492. The FETs 500, 502 can be formed using a process similar to that of previous embodiments, for example the FIG. 45 embodiment, omitting the Schottky device 450 and resulting in the FETs 500, 502 as depicted in FIG. 50. A different Schottky diode conductor scheme can be used for the Schottky diode 504 for improved leakage, for example by replacing metal layers 400, 434, 442 with one or more different layers, at the cost of an additional mask. An increased inductance between the FETs 500, 502 and the Schottky diode 504 may result from the lack of Schottky JFET protection. Additionally, a loss of area may result due to allocation of a portion of the die to the Schottky diode 504.

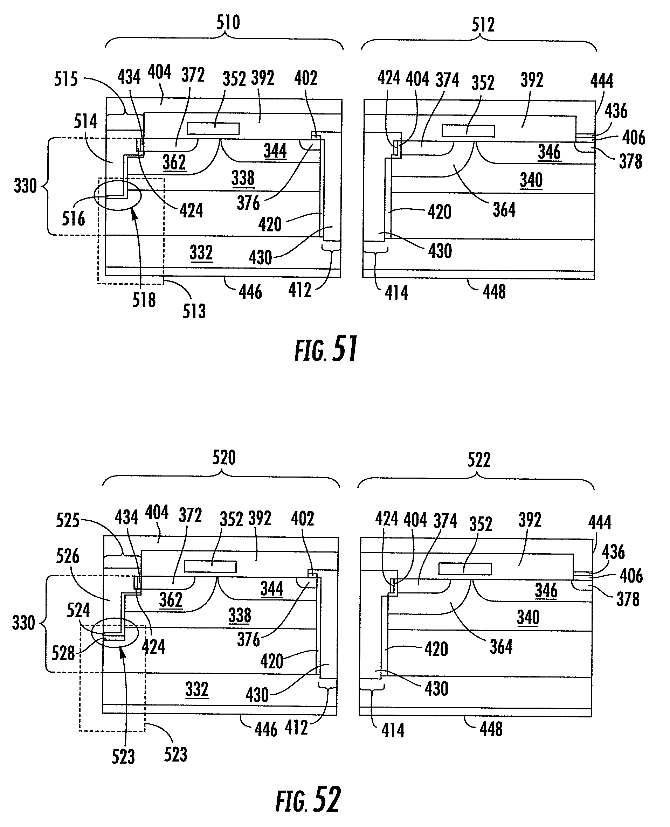

The device of FIG. 51 depicts a low side FET 510, a high side FET 512, and a Schottky diode 513 including contact between a trench conductor and epitaxial layer 330. The trench conductor can include a trench fill layer 514 alone, or the trench conductor can include a plurality of conductive layers such as a silicide layer 516 and a trench fill layer 514. The Schottky diode 513 includes contact between the trench conductor 514, 516 and the N-epitaxial layer 330 at location 518. Conductor 514 can include doped polysilicon or a metal such as tungsten, while conductor 516 can include a silicide for enhanced conduction. The trench conductor 514, 516 does not provide JFET protection of the Schottky diode 513. The Schottky diode 513 can be integrated with the FETs 510, 512 at the die level. The low side FET 510 and the high side FET 512 can be formed using a process similar to that of previous embodiments, for example the FIG. 45 embodiment, omitting the Schottky device 450 and resulting in the FETs 510, 512 as depicted in FIG. 51. This device may have a reduced mask count, as the P-buried regions 338, 340 and the P-body regions 362, 364 may be formed with an unmasked implant.

To form the structure of FIG. 51, a Schottky diode trench 515 can be etched on the source side of the low side FET 510. The Schottky diode trench 515 can be etched within the epitaxial layer 330 to a depth which is just at the bottom of the P-buried layer 338, or which is slightly below the P-buried layer 338 and into the N-type doping of the epitaxial layer 330.

The device of FIG. 52 includes a low side FET 520, a high side FET 522, and a Schottky diode 523. The Schottky diode can include contact between trench conductor 524 and N-type epitaxial layer 330, and can be integrated with the low side FET 520 at the die level. A Schottky diode trench 525 can be formed in a manner similar to that of the FIG. 51 device described above. A silicide layer 524 can be formed using a salicide process to enhance conduction with a Schottky diode trench conductor 526 such as doped polysilicon or tungsten which fills the Schottky diode trench 525. The Schottky diode trench conductor 526 and/or Schottky diode silicide layer 524 electrically couples the P-body region 362, the P-buried layer 338, and the N-type epitaxial layer 330.

A co-implant and one or more tuning implants 528 can help provide guarding from the P-buried layer 338. Suitable tuning implants and implant regions are discussed in co-pending U.S. utility patent application Serial No. 12/770,074 titled "Integrated Guarded Schottky Diode Compatible with Trench-Gate DMOS, Structure and Method," filed April 28, 2010, which is incorporated herein by reference.

With the structure of FIG. 52, the FET portion 520, 522 can be formed using a process similar to that of previous embodiments, for example the FIG. 45 embodiment, omitting the Schottky diode 450 and resulting in the FETs 520, 522 as depicted in FIG. 52. As with the FIG. 51 structure, reduced mask count can result as masks to define the P-buried layer and the P-body layer can be omitted. A higher device leakage than is found with some previous embodiments may result.

Additionally, the P-body or P-buried layer of the FET and their combination can provide a JFET effect which reduces Schottky diode leakage. These advantages can be realized using only one additional mask dedicated for the Schottky diode, and can result in a device which has a reduced number of discrete parts. Integrating the Schottky diode with the low side FET, which can result in higher R_{ONSP}, requires only a minimal increase in used die space. Additionally, a higher leakage current in the low side FET can result from the presence of the Schottky diode.

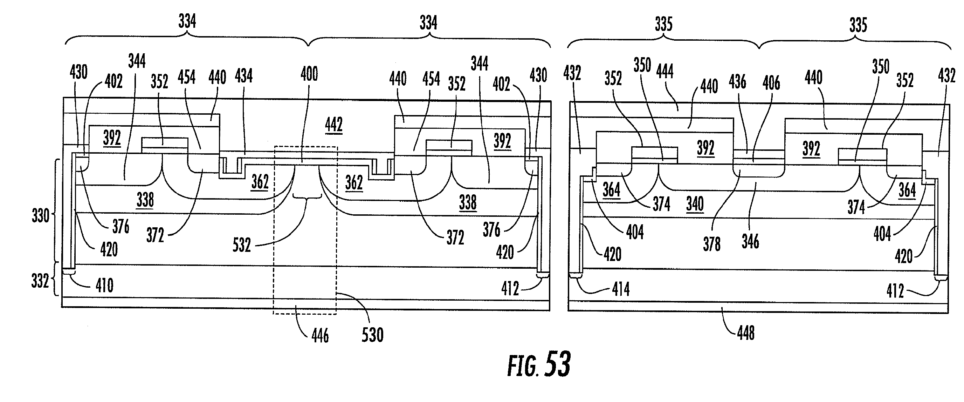

FIG. 53 depicts a device formed in accordance with an embodiment of the present teachings. The device of FIG. 53 includes two low side FETs 334 formed adjacent to each other and two high side FETs 335 formed adjacent to each other. The structures identified by the reference numbers and the operation of the device are similar to those describe with reference to FIG. 45. The Schottky diode 530 provides Schottky protection for the two adjacent low side FETs 334, and includes contact between silicide 400 and epitaxial layer 330. During formation, openings within the PBL mask 336 (FIG. 33) and the P-body mask 360 (FIG. 36) should be formed to provide a distance 532 between adjacent PBL regions 338 and P-body regions 362 such that the P-type PBL regions 338 are spaced from each other with the N-type epitaxial layer, as are the P-type P-body regions 362.

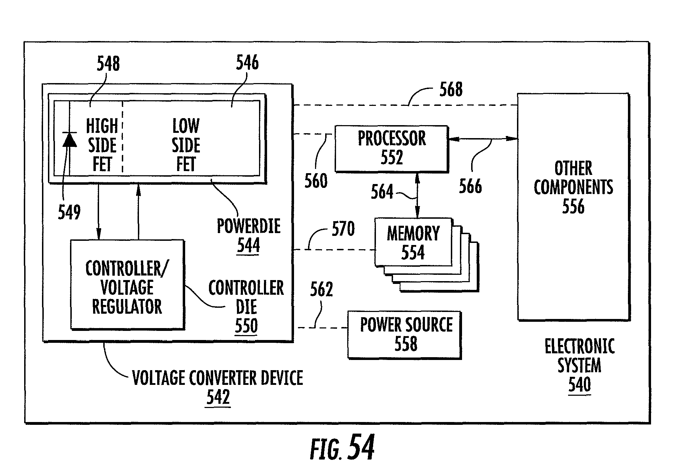

A voltage converter device including a Schottky diode as described in the various embodiments above may be attached along with other semiconductor devices such as one or more microprocessors to a printed circuit board, for example to a computer motherboard, for use as part of an electronic system such as a personal computer, a minicomputer, a mainframe, or another electronic system. A particular embodiment of an electronic system 540 according to the present teachings is depicted in the block diagram of FIG. 54. The electronic system 540 can include a voltage converter device 542 such as one according to the present teachings. The voltage converter device 542 can include a first die (e.g. a PowerDie) 544 having at least one low side LDMOS FET 546 and at least one high side LDMOS FET 548 on the same semiconductor substrate (i.e., the same piece of semiconductor material, such as a single silicon die, gallium die, etc.). The PowerDie 544 can further include at least one Schottky diode 549 in accordance with one of the embodiments described above. The voltage converter device 542 can further include a second die (e.g. a controller die) 550 which can include a controller/voltage regulator. The electronic system can further include a processor 552 which may be one or more of a microprocessor, microcontroller, embedded processor, digital signal processor, or a combination of two or more of the foregoing. Electronic system 540 can further include one or more memory devices 554 such as static random access memory, dynamic random access memory, read only memory, flash memory, or a combination of two or more of the foregoing. Other components 556 can also be included, which will vary with the type of electronic device. The voltage converter device 542 can be powered by a power source (power supply) 558 through a first power bus 562. The power source 558 may be a converted AC power source or a DC power source such as a DC power supply or battery. The processor 552 can be powered through a second power bus 560 using electricity converted by the voltage converter device 542. The other components 556 can be powered through a third power bus 568 using electricity converted by the voltage converter device 542. The memory 554 can be powered through a fourth power bus 570 using electricity converted by the converter device 542 or, in a alternate embodiment, through a different power management IC set. Thus, electronic system 540 may be a device related to telecommunications, the automobile industry, semiconductor test and manufacturing equipment, consumer electronics, or virtually any piece of consumer or industrial electronic equipment.

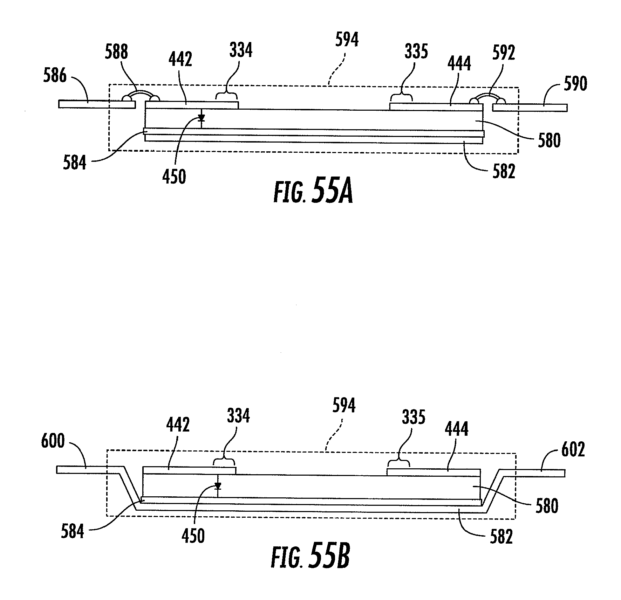

FIG. 55A depicts a first cross section at a first device location, and FIG. 55B depicts a second cross section at a second device location, of a semiconductor device comprising a voltage converter in accordance with an embodiment of the present teachings. While the voltage converter may include a device output stage in accordance with any of the embodiments of the present teachings, the semiconductor device of FIGS. 55A and 55B will be described using the FIG. 44 structure as an example for clarity. It will be understood that any embodiment of the present teachings, or variations of any embodiment of the present teachings, can be used for the embodiment described with reference to FIGS. 55A and 55B

FIG. 55A depicts low side FET 334, high side FET 335, Schottky diode 450, conductive layer 442, and conductive layer 444, as well as the other FIG. 44 structures which are not depicted for simplicity of explanation. FIG. 55A depicts a semiconductor wafer substrate assembly 580 which can include the semiconductor substrate 332 and epitaxial layer 330 of FIG. 44. The semiconductor wafer substrate assembly 580 can be attached to a lead frame die pad 582, for example using a conductive die attach adhesive 584. Thus, the back side conductive layer 446 (FIG. 44) is electrically coupled to the lead frame die pad 582 through the conductive die attach adhesive 584. FIG. 55A further depicts a lead frame first lead 586 which is electrically coupled to conductive layer 442 through a first bond wire 558. A lead frame second lead 590 is electrically coupled to conductive layer 444 through a second bond wire 592.

During use, lead frame first lead 586 can be electrically coupled with device ground (P_{GND}) to electrically couple conductive layer 442 and the source 372 (FIG. 44) of the low side FET 334 to P_{GND}. Also, lead frame second lead 590 can be electrically coupled with device voltage in (V_{IN}) to electrically couple conductive layer 444 and the drain 378 of the high side FET 335 to V_{IN}. After attaching the semiconductor wafer substrate assembly 580 to the die pad 582 of the lead frame, the device can be encapsulated in encapsulation material 594 or otherwise packaged.

The second cross section of FIG. 55B depicts a lead frame third lead 600 and a lead frame second lead 602 which are continuous with the lead frame die pad 582. FIG. 55B also depicts the conductive die attach material 584. Thus, the conductive die attach material 584 electrically couples the back side conductor 446 (FIG. 44) to the lead frame die pad 582 and to the lead frame first lead 600 and the lead frame second lead 602. Because back side conductor 446 can provide the switched node of the device, the switched node can be accessed through lead frame leads 600, 602.

It will be understood that more than one semiconductor die can be attached to the lead frame of FIGS. 55A, 55B. For example, as depicted in FIG. 1, a first semiconductor die, such as a PowerDie including the high side FET 14 and the low side FET 16, and a second die 12, such as a controller die, can be attached to a single lead frame and co-packaged to provide a single semiconductor device.

The present teachings have been described with reference to an output stage for a DC to DC voltage converter. It will be realized that the present teachings are also applicable to other semiconductor device circuit stages in addition to a voltage converter output stage, for example various semiconductor device driver stages such analog driver stages.

Notwithstanding that the numerical ranges and parameters setting forth the broad scope of the invention are approximations, the numerical values set forth in the specific examples are reported as precisely as possible. Any numerical value, however, inherently contains certain errors necessarily resulting from the standard deviation found in their respective testing measurements. Moreover, all ranges disclosed herein are to be understood to encompass any and all sub-ranges subsumed therein. For example, a range of "less than 10" can include any and all sub-ranges between (and including) the minimum value of zero and the maximum value of 10, that is, any and all sub-ranges having a minimum value of equal to or greater than zero and a maximum value of equal to or less than 10, e.g., 1 to 5. In certain cases, the numerical values as stated for the parameter can take on negative values. In this case, the example value of range stated as "less that 10" can assume negative values, e.g.-1, -2, -3, -10, -20, -30, etc.

While the invention has been illustrated with respect to one or more implementations, alterations and/or modifications can be made to the illustrated examples without departing from the spirit and scope of the appended claims. In addition, while a particular feature of the invention may have been disclosed with respect to only one of several implementations, such feature may be combined with one or more other features of the other implementations as may be desired and advantageous for any given or particular function. Furthermore, to the extent that the terms "including," "includes," "having," "has," "with," or variants thereof are used in either the detailed description and the claims, such terms are intended to be inclusive in a manner similar to the term "comprising." The term "at least one of" is used to mean one or more of the listed items can be selected. Further, in the discussion and claims herein, the term "on" used with respect to two materials, one "on" the other, means at least some contact between the materials, while "over" means the materials are in proximity, but possibly with one or more additional intervening materials such that contact is possible but not required. Neither "on" nor "over" implies any directionality as used herein. The term "conformal" describes a coating material in which angles of the underlying material are preserved by the conformal material. The term "about" indicates that the value listed may be somewhat altered, as long as the alteration does not result in nonconformance of the process or structure to the illustrated embodiment. Finally, "exemplary" indicates the description is used as an example, rather than implying that it is an ideal. Other embodiments of the invention will be apparent to those skilled in the art from consideration of the specification and practice of the invention disclosed herein. It is intended that the specification and examples be considered as exemplary only, with a true scope and spirit of the invention being indicated by the following claims.

Terms of relative position as used in this application are defined based on a plane parallel to the conventional plane or working surface of a wafer or substrate, regardless of the orientation of the wafer or substrate. The term "horizontal" or "lateral" as used in this application is defined as a plane parallel to the conventional plane or working surface of a wafer or substrate, regardless of the orientation of the wafer or substrate. The term "vertical" refers to a direction perpendicular to the horizontal. Terms such as "on," "side" (as in "sidewall"), "higher," "lower," "over," "top," and "under" are defined with respect to the conventional plane or working surface being on the top surface of the wafer or substrate, regardless of the orientation of the wafer or substrate.

A semiconductor device circuit stage of the invention comprises: a semiconductor die comprising at least one semiconductor layer, a circuit side and a non-circuit side; a high side lateral diffusion metal oxide semiconductor (LDMOS) field effect transistor (FET) on the circuit side of the semiconductor die; a source region and a drain region of the high side LDMOS FET; a low side LDMOS FET on the circuit side of the semiconductor die; a source region of the low side LDMOS FET within the semiconductor layer; a drain region of the low side LDMOS FET, wherein the drain region of the low side LDMOS FET is electrically coupled with the source region of the high side LDMOS FET; a body region of the low side LDMOS FET within the semiconductor layer; an output node electrically coupled with the source region of the high side LDMOS FET and the drain region of the low side LDMOS FET; a conductive layer over the semiconductor layer which is electrically coupled with the body region of the low side LDMOS FET and with the source region of the low side LDMOS FET; and at least one Schottky diode including contact between the conductive layer and a doped region of the semiconductor layer.
Preferably, the semiconductor device circuit stage of the invention further comprises: the body region of the low side LDMOS FET comprises a net first-type conductivity; the doped region of the semiconductor layer comprises a net second-type conductivity which is opposite to the first type conductivity; and a junction between the body region of the low side LDMOS FET and the doped region of the semiconductor layer which provides junction FET (JFET) protection for the Schottky diode.
Preferably, the semiconductor device circuit stage of the invention further comprises: a buried layer of the low side LDMOS FET; the buried layer is doped to the net first-type conductivity; the body region is within the buried layer; and an edge of the body region is generally aligned with an edge of the buried layer.
Preferably, in the semiconductor device circuit stage of the invention the buried layer is a first buried layer and the body region is a first body region, further comprises: a second buried layer spaced from the first buried layer by the doped region of the semiconductor layer; and a second body region spaced from the first body region by the doped region of the semiconductor layer.
Preferably, the semiconductor device circuit stage of the invention, wherein the body region is a first body region, further comprises: a second body region spaced from the first body region by the doped region of the semiconductor layer.
Preferably, the semiconductor device circuit stage of the invention further comprises: a buried layer of the low side LDMOS FET; the buried layer is doped to the net first-type conductivity; a portion of the body region is within the buried layer; and an end of the body region extends beyond an end of the buried layer.
Preferably, the semiconductor device circuit stage of the invention further comprises: a buried layer of the low side LDMOS FET; the body region is nested within the buried layer.
Preferably, the semiconductor device circuit stage of the invention further comprises: a buried layer of the low side LDMOS FET comprising a net first-type conductivity; the body region of the low side LDMOS FET comprises the net first-type conductivity; the doped region of the semiconductor layer comprises a net second-type conductivity which is opposite to the first type conductivity; and the Schottky diode is free from a region of the net first-type conductivity.
Preferably, in the semiconductor device circuit stage of the invention the conductive layer further comprises a trench conductor within a trench in the semiconductor layer.
Preferably, in the semiconductor device circuit stage of the invention the trench conductor comprises a silicide layer and a metal layer.
Preferably, the semiconductor device circuit stage of the invention further comprises: a tuning implant within the semiconductor layer electrically coupled with the trench conductor.
Preferably, the semiconductor device circuit stage of the invention further comprises: a lead frame first lead electrically coupled with the source region of the low side LDMOS FET; a lead frame second lead electrically coupled with the drain region of the high side LDMOS FET; and a lead frame third lead electrically coupled with the non-circuit side of the semiconductor die.
Preferably, in the semiconductor device circuit stage of the invention, during operation of the semiconductor device circuit stage: the lead frame first lead is electrically coupled with device ground; and the lead frame second lead is electrically coupled with device voltage in.

A further semiconductor device circuit stage of the invention comprises: a semiconductor die, comprising: a single semiconductor substrate comprising at least one semiconductor layer; a low side transistor over the single semiconductor substrate and comprising a source region within the semiconductor layer, a drain region within the semiconductor layer, a body region within the semiconductor layer, and a transistor gate; a high side transistor over the single semiconductor substrate and comprising a source region within the semiconductor layer, a drain region within the semiconductor layer, and a transistor gate; a first conductive structure within the semiconductor die and interposed between the drain region of the low side transistor and the source region of the high side transistor, wherein the conductive structure is electrically coupled with the semiconductor substrate, with the drain region of the low side transistor, and with the source region of the high side transistor; the drain region of the low side transistor is electrically coupled to the source region of the high side transistor through at least the first conductive structure; the drain region of the high side transistor is electrically connected to a device voltage in (V_{IN}) pinout; the source region of the low side transistor is electrically connected to a device ground (P_{GND}) pinout; and a second conductive structure within the semiconductor die which electrically couples the body region of the low side transistor to the source region of the low side transistor; and at least one Schottky diode including contact between the second conductive structure and the semiconductor layer.
Preferably, the semiconductor device circuit stage of the invention further comprises: the body region of the low side transistor is doped to a net first-type conductivity; the semiconductor layer comprises a region doped to a net second-type conductivity which is opposite to the first type conductivity; and a junction between the body region of the low side transistor and the semiconductor layer region doped to the net second type conductivity which provides junction FET (JFET) protection for the Schottky diode.
Preferably, the semiconductor device circuit stage of the invention further comprises: a buried layer of the low side transistor; the buried layer is doped to the net first-type conductivity; the body region is within the buried layer; and an edge of the body region is generally aligned with an edge of the buried layer.
Preferably, the semiconductor device circuit stage of the invention further comprises: a buried layer of the low side transistor; the buried layer is doped to the net first-type conductivity; a portion of the body region is within the buried layer; and an end of the body region extends beyond an end of the buried layer.

An electronic system of the invention comprises: a voltage converter, comprising: a first semiconductor die comprising voltage converter controller circuitry; a second semiconductor die comprising at least one semiconductor layer, a circuit side and a non-circuit side; a high side lateral diffusion metal oxide semiconductor (LDMOS) field effect transistor (FET) on the circuit side of the second semiconductor die; a source region of the high side LDMOS FET; a low side LDMOS FET on the circuit side of the second semiconductor die; a drain region of the low side LDMOS FET electrically coupled with the source region of the high side LDMOS FET; a source region of the low side LDMOS FET within the semiconductor layer; a body region of the low side LDMOS FET within the semiconductor layer; an output node of the circuit stage electrically coupled with the source region of the high side LDMOS FET and the drain region of the low side LDMOS FET; a conductive layer over the semiconductor layer which is electrically coupled with the body region of the low side LDMOS FET and with the source region of the low side LDMOS FET; and at least one Schottky diode including contact between the conductive layer and the semiconductor layer; a power source which powers the voltage converter device through a first power bus; a processor electrically coupled to the voltage converter device through a second power bus; and memory coupled to the processor through a data bus.

A method for forming a semiconductor device circuit stage of the invention comprises: forming a conductive layer over a semiconductor substrate of a semiconductor die, wherein: forming the conductive layer electrically couples a source region of a low side lateral diffusion metal oxide semiconductor (LDMOS) field effect transistor (FET) to a body region of the LDMOS FET, and forming the conductive layer electrically contacts the conductive layer with a doped region of the semiconductor substrate, wherein a Schottky diode includes the electrical contact between the conductive layer and the doped region of the semiconductor substrate; electrically coupling a drain region of the low side LDMOS FET with a source region of a high side LDMOS FET; electrically coupling the source region of the low side LDMOS FET with a device ground pinout; and electrically coupling a drain region of a high side LDMOS FET with a device voltage in pinout.

A further method for forming a semiconductor device circuit stage of the invention comprises: implanting a source region for a low side transistor into a single semiconductor substrate; implanting a drain region for the low side transistor into the single semiconductor substrate; implanting a body region for the low side transistor into the single semiconductor substrate; and etching a gate layer to form a low side transistor gate over the single semiconductor substrate; implanting a source region for a high side transistor into the single semiconductor substrate; implanting a drain region for the high side transistor into the single semiconductor substrate; and etching the gate layer to form a high side transistor gate over the single semiconductor substrate; forming a conductive structure between the low side transistor drain region and the high side transistor source region, wherein the conductive structure is electrically coupled to the single semiconductor substrate through contact between the conductive structure and the single semiconductor substrate; forming a first conductive layer which electrically couples the conductive structure to the drain region of the low side transistor; forming a second conductive layer which electrically couples the drain region of the low side transistor to the source region of the high side transistor; and forming a third conductive layer over the single semiconductor layer which electrically couples the body region of the low side transistor to the source region of the low side transistor, wherein at least one Schottky diode includes contact between the third conductive layer and the single semiconductor substrate.
Preferably, the method of the invention further comprises: implanting the body region of the low side transistor to a net first-type conductivity; and implanting a region of the semiconductor layer to a net second-type conductivity which is opposite to the first type conductivity, wherein a junction between the body region of the low side transistor and the region of the semiconductor layer doped to the net second type conductivity which provides junction FET (JFET) protection for the Schottky diode.
Preferably, the method of the invention further comprises: implanting a buried layer of the low side transistor into the semiconductor layer to the net first-type conductivity; the implanting of the body region forms the body region within the buried layer; and diffusing the buried layer and the body region such that, subsequent to the diffusion, an edge of the body region is generally aligned with an edge of the buried layer.
Preferably, the method of the invention further comprises: implanting a buried layer of the low side transistor to the net first-type conductivity; the implanting of the body region forms a portion of the body region within the buried layer; and the implanting of the body region forms an end of the body region which extends beyond an end of the buried layer.
Preferably, the method of the invention further comprises: electrically coupling a lead frame first lead to the source region of the low side LDMOS FET; electrically coupling a lead frame second lead to the drain region of the high side LDMOS FET; and attaching the non-circuit side of the semiconductor die to a lead frame die pad to electrically couple an output of the circuit stage to a lead frame third lead.
Preferably, the method of the invention further comprises: forming the conductive structure between the low side transistor drain region and the high side transistor source region comprises implanting a sinker region into the single semiconductor substrate.
Preferably, the method of the invention further comprises: forming the conductive structure between the low side transistor drain region and the high side transistor source region comprises etching a trench into the single semiconductor substrate and forming a trench conductor within the trench.

A further method for forming a semiconductor device circuit stage of the invention comprises: forming a low side transistor using a method comprising: implanting a source region for the low side transistor into a single semiconductor substrate; implanting a drain region for the low side transistor into the single semiconductor substrate; implanting a body region for the low side transistor into the single semiconductor substrate; and etching a gate layer to form a low side transistor gate over the single semiconductor substrate; forming a high side transistor using a method comprising: implanting a source region for the high side transistor into the single semiconductor substrate; implanting a drain region for the high side transistor into the single semiconductor substrate; and etching the gate layer to form a high side transistor gate over the single semiconductor substrate; forming a conductive structure between the low side transistor drain region and the high side transistor source region using a method comprising one of: implanting a sinker region into the single semiconductor substrate; or etching a trench into the single semiconductor substrate and forming a trench conductor within the trench, wherein the conductive structure is electrically coupled to the single semiconductor substrate through contact between the conductive structure and the single semiconductor substrate; forming a first conductive layer which electrically couples the conductive structure to the drain region of the low side transistor; forming a second conductive layer which electrically couples the drain region of the low side transistor to the source region of the high side transistor; etching into the single semiconductor substrate and through the source region of the low side transistor; etching into the single semiconductor substrate and into the body region of the low side transistor to form a Schottky diode trench in the single semiconductor substrate; and forming a Schottky diode trench conductor within the Schottky diode trench, wherein the Schottky diode trench conductor electrically couples the body region of the low side transistor to the source region of the low side transistor, wherein at least one Schottky diode includes contact between the third conductive layer and the single semiconductor substrate.

## Claims

1. A semiconductor device circuit stage, comprising:
a semiconductor die comprising at least one semiconductor layer, a circuit side and a non-circuit side;
a high side lateral diffusion metal oxide semiconductor (LDMOS) field effect transistor (FET) on the circuit side of the semiconductor die;
a source region and a drain region of the high side LDMOS FET;
a low side LDMOS FET on the circuit side of the semiconductor die;
a source region of the low side LDMOS FET within the semiconductor layer;
a drain region of the low side LDMOS FET, wherein the drain region of the low side LDMOS FET is electrically coupled with the source region of the high side LDMOS FET;
a body region of the low side LDMOS FET within the semiconductor layer;
an output node electrically coupled with the source region of the high side LDMOS FET and the drain region of the low side LDMOS FET;
a conductive layer over the semiconductor layer which is electrically coupled with the body region of the low side LDMOS FET and with the source region of the low side LDMOS FET; and
at least one Schottky diode including contact between the conductive layer and a doped region of the semiconductor layer.

2. The semiconductor device circuit stage of claim 1, further comprising:
the body region of the low side LDMOS FET comprises a net first-type conductivity;
the doped region of the semiconductor layer comprises a net second-type conductivity which is opposite to the first type conductivity; and
a junction between the body region of the low side LDMOS FET and the doped region of the semiconductor layer which provides junction FET (JFET) protection for the Schottky diode.

3. The semiconductor device circuit stage of claim 2, further comprising:
a buried layer of the low side LDMOS FET;
the buried layer is doped to the net first-type conductivity;
the body region is within the buried layer; and
an edge of the body region is generally aligned with an edge of the buried layer.

4. The semiconductor device circuit stage of claim 3, wherein the buried layer is a first buried layer and the body region is a first body region, further comprising:
a second buried layer spaced from the first buried layer by the doped region of the semiconductor layer; and
a second body region spaced from the first body region by the doped region of the semiconductor layer.

5. The semiconductor device circuit stage of claim 2, wherein the body region is a first body region, further comprising:
a second body region spaced from the first body region by the doped region of the semiconductor layer.

6. The semiconductor device circuit stage of claim 2, further comprising:
a buried layer of the low side LDMOS FET;
the buried layer is doped to the net first-type conductivity;
a portion of the body region is within the buried layer; and
an end of the body region extends beyond an end of the buried layer.

7. The semiconductor device circuit stage of claim 2, further comprising:
a buried layer of the low side LDMOS FET;
the body region is nested within the buried layer.

8. The semiconductor device circuit stage of claim 1, further comprising:
a buried layer of the low side LDMOS FET comprising a net first-type conductivity;
the body region of the low side LDMOS FET comprises the net first-type conductivity;
the doped region of the semiconductor layer comprises a net second-type conductivity which is opposite to the first type conductivity; and
the Schottky diode is free from a region of the net first-type conductivity.

9. The semiconductor device circuit stage of claim 1, wherein the conductive layer further comprises a trench conductor within a trench in the semiconductor layer.

10. The semiconductor device circuit stage of claim 9, wherein the trench conductor comprises a silicide layer and a metal layer.

11. The semiconductor device circuit stage of claim 9, further comprising:
a tuning implant within the semiconductor layer electrically coupled with the trench conductor.

12. The semiconductor device circuit stage of claim 1, further comprising:
a lead frame first lead electrically coupled with the source region of the low side LDMOS FET;
a lead frame second lead electrically coupled with the drain region of the high side LDMOS FET; and
a lead frame third lead electrically coupled with the non-circuit side of the semiconductor die.

13. The semiconductor device circuit stage of claim 12, wherein, during operation of the semiconductor device circuit stage:
the lead frame first lead is electrically coupled with device ground; and
the lead frame second lead is electrically coupled with device voltage in.

14. A semiconductor device circuit stage, comprising:
a semiconductor die, comprising:
a single semiconductor substrate comprising at least one semiconductor layer;
a low side transistor over the single semiconductor substrate and comprising a source region within the semiconductor layer, a drain region within the semiconductor layer, a body region within the semiconductor layer, and a transistor gate;
a high side transistor over the single semiconductor substrate and comprising a source region within the semiconductor layer, a drain region within the semiconductor layer, and a transistor gate;
a first conductive structure within the semiconductor die and interposed between the drain region of the low side transistor and the source region of the high side transistor, wherein the conductive structure is electrically coupled with the semiconductor substrate, with the drain region of the low side transistor, and with the source region of the high side transistor;
the drain region of the low side transistor is electrically coupled to the source region of the high side transistor through at least the first conductive structure;
the drain region of the high side transistor is electrically connected to a device voltage in (V_{IN}) pinout;
the source region of the low side transistor is electrically connected to a device ground (P_{GND}) pinout; and
a second conductive structure within the semiconductor die which electrically couples the body region of the low side transistor to the source region of the low side transistor; and
at least one Schottky diode including contact between the second conductive structure and the semiconductor layer.

15. The semiconductor device circuit stage of claim 14, further comprising:
the body region of the low side transistor is doped to a net first-type conductivity;
the semiconductor layer comprises a region doped to a net second-type conductivity which is opposite to the first type conductivity; and
a junction between the body region of the low side transistor and the semiconductor layer region doped to the net second type conductivity which provides junction FET (JFET) protection for the Schottky diode.

16. The semiconductor device circuit stage of claim 15, further comprising:
a buried layer of the low side transistor;
the buried layer is doped to the net first-type conductivity;
the body region is within the buried layer; and
an edge of the body region is generally aligned with an edge of the buried layer.

17. The semiconductor device circuit stage of claim 15, further comprising:
a buried layer of the low side transistor;
the buried layer is doped to the net first-type conductivity;
a portion of the body region is within the buried layer; and
an end of the body region extends beyond an end of the buried layer.

18. An electronic system comprising:
a voltage converter, comprising:
a first semiconductor die comprising voltage converter controller circuitry;
a second semiconductor die comprising at least one semiconductor layer, a circuit side and a non-circuit side;
a high side lateral diffusion metal oxide semiconductor (LDMOS) field effect transistor (FET) on the circuit side of the second semiconductor die;
a source region of the high side LDMOS FET;
a low side LDMOS FET on the circuit side of the second semiconductor die;
a drain region of the low side LDMOS FET electrically coupled with the source region of the high side LDMOS FET;
a source region of the low side LDMOS FET within the semiconductor layer;
a body region of the low side LDMOS FET within the semiconductor layer;
an output node of the circuit stage electrically coupled with the source region of the high side LDMOS FET and the drain region of the low side LDMOS FET;
a conductive layer over the semiconductor layer which is electrically coupled with the body region of the low side LDMOS FET and with the source region of the low side LDMOS FET; and
at least one Schottky diode including contact between the conductive layer and the semiconductor layer;
a power source which powers the voltage converter device through a first power bus;
a processor electrically coupled to the voltage converter device through a second power bus; and
memory coupled to the processor through a data bus.

19. A method for forming a semiconductor device circuit stage, comprising:
forming a conductive layer over a semiconductor substrate of a semiconductor die, wherein:
forming the conductive layer electrically couples a source region of a low side lateral diffusion metal oxide semiconductor (LDMOS) field effect transistor (FET) to a body region of the LDMOS FET, and
forming the conductive layer electrically contacts the conductive layer with a doped region of the semiconductor substrate, wherein a Schottky diode includes the electrical contact between the conductive layer and the doped region of the semiconductor substrate;
electrically coupling a drain region of the low side LDMOS FET with a source region of a high side LDMOS FET;
electrically coupling the source region of the low side LDMOS FET with a device ground pinout; and
electrically coupling a drain region of a high side LDMOS FET with a device voltage in pinout.

20. A method for forming a semiconductor device circuit stage, comprising:
implanting a source region for a low side transistor into a single semiconductor substrate;
implanting a drain region for the low side transistor into the single semiconductor substrate;
implanting a body region for the low side transistor into the single semiconductor substrate; and
etching a gate layer to form a low side transistor gate over the single semiconductor substrate;
implanting a source region for a high side transistor into the single semiconductor substrate;
implanting a drain region for the high side transistor into the single semiconductor substrate; and
etching the gate layer to form a high side transistor gate over the single semiconductor substrate;
forming a conductive structure between the low side transistor drain region and the high side transistor source region, wherein the conductive structure is electrically coupled to the single semiconductor substrate through contact between the conductive structure and the single semiconductor substrate;
forming a first conductive layer which electrically couples the conductive structure to the drain region of the low side transistor;
forming a second conductive layer which electrically couples the drain region of the low side transistor to the source region of the high side transistor; and
forming a third conductive layer over the single semiconductor layer which electrically couples the body region of the low side transistor to the source region of the low side transistor,
wherein at least one Schottky diode includes contact between the third conductive layer and the single semiconductor substrate.

21. The method of claim 20, further comprising:
implanting the body region of the low side transistor to a net first-type conductivity; and
implanting a region of the semiconductor layer to a net second-type conductivity which is opposite to the first type conductivity, wherein
a junction between the body region of the low side transistor and the region of the semiconductor layer doped to the net second type conductivity which provides junction FET (JFET) protection for the Schottky diode.

22. The method of claim 21, further comprising:
implanting a buried layer of the low side transistor into the semiconductor layer to the net first-type conductivity;
the implanting of the body region forms the body region within the buried layer; and
diffusing the buried layer and the body region such that, subsequent to the diffusion, an edge of the body region is generally aligned with an edge of the buried layer.

23. The method of claim 22, further comprising:
implanting a buried layer of the low side transistor to the net first-type conductivity;
the implanting of the body region forms a portion of the body region within the buried layer; and
the implanting of the body region forms an end of the body region which extends beyond an end of the buried layer.

24. The method of claim 20, further comprising:
electrically coupling a lead frame first lead to the source region of the low side LDMOS FET;
electrically coupling a lead frame second lead to the drain region of the high side LDMOS FET; and
attaching the non-circuit side of the semiconductor die to a lead frame die pad to electrically couple an output of the circuit stage to a lead frame third lead.

25. The method of claim 20, further comprising:
forming the conductive structure between the low side transistor drain region and the high side transistor source region comprises implanting a sinker region into the single semiconductor substrate

26. The method of claim 20, further comprising:
forming the conductive structure between the low side transistor drain region and the high side transistor source region comprises etching a trench into the single semiconductor substrate and forming a trench conductor within the trench.

27. A method for forming a semiconductor device circuit stage, comprising:
forming a low side transistor using a method comprising:
implanting a source region for the low side transistor into a single semiconductor substrate;
implanting a drain region for the low side transistor into the single semiconductor substrate;
implanting a body region for the low side transistor into the single semiconductor substrate; and
etching a gate layer to form a low side transistor gate over the single semiconductor substrate;
forming a high side transistor using a method comprising:
implanting a source region for the high side transistor into the single semiconductor substrate;
implanting a drain region for the high side transistor into the single semiconductor substrate; and
etching the gate layer to form a high side transistor gate over the single semiconductor substrate;
forming a conductive structure between the low side transistor drain region and the high side transistor source region using a method comprising one of:
implanting a sinker region into the single semiconductor substrate; or
etching a trench into the single semiconductor substrate and forming a trench conductor within the trench,
wherein the conductive structure is electrically coupled to the single semiconductor substrate through contact between the conductive structure and the single semiconductor substrate;
forming a first conductive layer which electrically couples the conductive structure to the drain region of the low side transistor;
forming a second conductive layer which electrically couples the drain region of the low side transistor to the source region of the high side transistor;
etching into the single semiconductor substrate and through the source region of the low side transistor;
etching into the single semiconductor substrate and into the body region of the low side transistor to form a Schottky diode trench in the single semiconductor substrate; and
forming a Schottky diode trench conductor within the Schottky diode trench, wherein the Schottky diode trench conductor electrically couples the body region of the low side transistor to the source region of the low side transistor,
wherein at least one Schottky diode includes contact between the third conductive layer and the single semiconductor substrate.
